(19) Europäisches Patentamt
European Patent Office
Office européen des brevets

(11) **EP 2 020 679 A1**

(12) **EUROPEAN PATENT APPLICATION**
published in accordance with Art. 153(4) EPC

(43) Date of publication:
**04.02.2009 Bulletin 2009/06**

(51) Int Cl.:
***H01L 21/027*** (2006.01)

(21) Application number: **07742128.7**

(22) Date of filing: **23.04.2007**

(86) International application number:
**PCT/JP2007/058693**

(87) International publication number:
**WO 2007/138805 (06.12.2007 Gazette 2007/49)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **25.05.2006 JP 2006145179**

(71) Applicant: **Nikon Corporation
Tokyo 100-8331 (JP)**

(72) Inventor: **KOMATSUDA, Hideki
Chiyoda-ku, Tokyo 100-8331 (JP)**

(74) Representative: **Hooiveld, Arjen Jan Winfried et al
Arnold & Siedsma
Sweelinckplein 1
2517 GK Den Haag (NL)**

(54) **ILLUMINATING OPTICAL APPARATUS, EXPOSURE APPARATUS, AND DEVICE MANUFACTURING METHOD**

(57) There is an illumination optical apparatus capable of forming an intensity distribution profile of light in an exit pupil that is substantially symmetrical with respect to an axis or substantially symmetrical and substantially identical in shape in two perpendicular directions with respect to an axis to illuminate an illumination surface under desired illumination conditions. The illumination optical apparatus includes a first fly's-eye optical system (18a) having first optical components and a second fly's-eye optical system (18b) having second optical components arranged in parallel in one-to-one correspondence to the first optical components. An illumination surface (M) is illuminated with light from each of the second optical components in an overlapping manner. The correspondence relationship between the first optical components and the second optical components is established so that an intensity distribution profile of light in an exit pupil of the illumination optical apparatus is substantially symmetrical with respect to an axis or substantially symmetrical and substantially identical in shape in two perpendicular directions with respect to an axis.

Fig.2

EP 2 020 679 A1

**Description**

TECHNICAL FIELD

The present invention relates to an illumination optical apparatus, an exposure apparatus, and a device manufacturing method. More particularly, the present invention relates to an illumination optical apparatus incorporated with an exposure apparatus for manufacturing devices in a lithographic process. The manufactured devices may include semiconductor devices, image-pickup devices, liquid crystal display devices, and thin-film magnetic heads.

BACKGROUND ART

In a conventional exposure apparatus for manufacturing semiconductor devices, a circuit pattern formed on a mask (reticle) is projected through a projection optical system onto a photosensitive substrate (e.g., a wafer) coated with a resist, so that the resist is exposed with exposure light through a projection optical system so as to obtain a resist pattern corresponding to the circuit pattern. The resolution of the exposure apparatus depends primarily on the wavelength of the exposure light and the numerical aperture of the projection optical system.

To improve the resolution, it is necessary to reduce the wavelength of the exposure light and increase the numerical aperture of the projection optical system. In general, it is difficult to increase the numerical aperture of the projection optical system up to more than a predetermined value from the aspect of optical designing. Accordingly, the wavelength of the exposure light needs to be reduced. Thus, an extreme ultraviolet lithography (EUVL) technique has been developed as a next generation exposure method (exposure apparatus) for semiconductor patterning.

In an EUVL exposure apparatus, extreme ultraviolet (EUV) light having a wavelength of about 5 to 20 nm is employed. The wavelength of the EUV light is shorter than the wavelength (248 nm) of KrF excimer laser and the wavelength (193 nm) of ArF excimer laser, which are employed in conventional exposure apparatuses. When EUV light is employed as the exposure light, a light transmissible optical material is not available. Hence, the EUVL exposure apparatus incorporates a reflection optical integrator, a reflection mask, and a reflection projection optical system (see, for example, patent document 1).

Patent Document 1: U.S. Patent No. 6,452,661

DISCLOSURE OF THE INVENTION

In not only the EUVL exposure apparatus but also any conventional exposure apparatus, it is preferable that the light intensity distribution formed on an exit pupil of an illumination optical apparatus (also referred to below as a "pupil intensity distribution") be substantially rotationally symmetrical about an optical axis or a central axis. However, as will be described later, in the illumination optical apparatus, incorporated in the EUVL exposure apparatus, it is difficult to obtain the rotationally symmetrical pupil intensity distribution. When the pupil intensity distribution is not rotationally symmetrical, the line width of an image formed on the photosensitive substrate differs corresponding to the direction of the pattern, so that the functions of the manufactured integrated circuit tend to deteriorate.

To overcome the above problems, it is an object of the present invention to provide an illumination optical apparatus capable of illuminating an illumination surface under desired illumination conditions by forming at an exit pupil a pupil intensity distribution substantially rotationally symmetrical with respect to an axis or substantially symmetrical and substantially identical in two perpendicular directions with respect to an axis. It is a further object of the present invention to provide an exposure apparatus capable of preferably performing exposure under preferable illumination conditions by employing the illumination optical apparatus illuminating a mask as an illumination surface under desired illumination conditions.

MEANS FOR SOLVING THE PROBLEMS

To solve the above problems, a first aspect of the present invention provides an illumination optical apparatus for illuminating an illumination surface with light from a light source. The illumination optical apparatus includes a first fly's-eye optical system having a plurality of first optical components arranged in parallel along an optical path between the light source and the illumination surface. A second fly's-eye optical system has a plurality of second optical components arranged in parallel along an optical path between the first fly's-eye optical system and the illumination surface. The second optical components are respectively arranged in correspondence with the first optical components. The illumination surface is illuminated with light from each of the second optical components in an overlapping manner. The corresponding relationship of the plurality of first optical components and the plurality of second optical components is established so that an intensity distribution profile of light in an exit pupil of the illumination optical apparatus is substantially rotationally symmetrical with respect to an axis or substantially symmetrical and substantially identical in shape in two perpendicular directions with respect to an axis.

A second aspect of the present invention provides an illumination optical apparatus for illuminating an illumination surface with light from a light source. The illumination optical apparatus includes a first fly's-eye optical system having an m number of first optical components arranged in parallel along an optical path between the light source and the illumination surface. A second fly's-eye optical system has an m number of second optical components arranged in parallel along an optical path between the first fly's-eye optical system and the illumination surface. The m number of second optical components are respectively arranged in correspondence with the m number of first optical components. The illumination surface is illuminated with light from each of the second optical components in an overlapping manner. When the m number of second optical components are hypothetically divided into an n number of component groups and an n number of any of the first optical components are arranged adjacent to one another in the first fly's-eye optical system, where n is obtained by rounding off decimal places of the square root of m so that each component group includes substantially the same quantity of the second optical components and each component group is inscribed with a rectangle having a longer side and a short side, in which a ratio of the length of the shorter side relative to the length of the longer side is 1/2 or greater, and when the quantity of the second optical components included in an i-th (i=1 to n) component group of the second fly's-eye optical system is represented by Pi, and the quantity of the second optical components included in an i-th (i=1 to n) component group of an n number of the second optical components corresponding to the n number of any of the first optical components is represented by Ri, a corresponding relationship between the m number of first optical components and the m number of second optical components is established so that an evaluation value H is larger than an average of a maximum value and a minimum value of the evaluation value H, the evaluation value H being defined as:

$$H = \sum_{i=1}^{n} (Ri / n / Pi / A) \times \log_2 (n \times Pi \times A / Ri) \qquad (1)$$

*where*

$$A = \sum_{i=1}^{n} Ri / n / Pi.$$

A third aspect of the present invention provides an exposure apparatus including the illumination optical apparatus according to the first aspect or second aspect and exposing a mask pattern arranged on the illumination surface onto a photosensitive substrate.

A fourth aspect of the present invention provides a device manufacturing method including an exposure step of exposing the mask pattern onto the photosensitive substrate using the exposure apparatus according to the third aspect, and a development step of developing the photosensitive substrate having the mask pattern exposed thereon.

EFFECT OF THE INVENTION

In one example of the present invention, when partial light is transferred from a first optical component of a first fly's-eye optical system to a second optical component of a second fly's-eye optical system, a partial light group reflected from the same group (the same component group) of the first fly's-eye optical system is led to positions dispersed on the incident surface of the second fly's-eye optical system. As a result, the profile of the pupil intensity distribution obtained in the example of the present invention takes a similar shape along an arbitrary direction passing through the axis, so that the profile is to be substantially rotation symmetrical with respect to an axis or substantially symmetrical with respect to an axis in two perpendicular directions and substantially identical in shape.

In such a manner, in the illumination optical apparatus according to the example of the present invention, an illumination surface can be illuminated under desired illumination conditions by forming at an exit pupil a pupil intensity distribution substantially rotationally symmetrical about an axis or substantially symmetrical about an axis and substantially identical in two perpendicular directions. Also, in the exposure apparatus according to the example of the present invention, by forming on an exit pupil a light intensity distribution substantially rotationally symmetrical about an axis or substantially symmetrical about an axis and substantially identical in two perpendicular directions using the illumination optical apparatus for illuminating a mask as an illumination surface under desired illumination conditions, devices with satisfactory functions can be manufactured by performing preferable exposure under favorable conditions.

BRIEF DESCRIPTION OF THE DRAWINGS

Fig. 1 is a schematic diagram illustrating an exposure apparatus according to an embodiment.

Fig. 2 is a schematic diagram illustrating a light source, an illumination optical system, and a projection optical system shown in Fig. 1.

Fig. 3 is a schematic diagram illustrating one-time scanning exposure according to the embodiment.

Fig. 4 is a schematic diagram illustrating an optical integrator according to the embodiment.

Fig. 5 is a schematic diagram illustrating a light intensity profile formed on an exit pupil of a conventional illumination optical apparatus, in which Fig. 5(a) shows the profile in x-direction and Fig. 5(b) shows the profile in y-direction.

Fig. 6 is a diagram illustrating a correspondence relationship between a plurality of first concave reflection mirror components and a plurality of second concave reflection mirror components according to one embodiment in a simplified one-dimensional model.

Fig. 7 is a diagram illustrating a correspondence relationship between a plurality of first concave reflection mirror components and a plurality of second concave reflection mirror components according to a first modification of the embodiment, in which Fig. 7(a) shows nine adjoining first concave reflection mirror components arranged in y-direction, and Fig. 7(b) shows nine adjoining second concave reflection mirror components arranged as a three-by-three array.

Fig. 8 is a diagram illustrating a correspondence relationship between a plurality of first concave reflection mirror components and a plurality of second concave reflection mirror components according to the first modification, in which Fig. 8(a) shows three adjoining first concave reflection mirror components arranged in y-direction, and Fig. 8(b) shows three adjoining second concave reflection mirror components arranged in x-direction.

Fig. 9 is a diagram illustrating a plurality of the first concave reflection mirror components in a first fly's-eye optical system, the first concave reflection mirror components being hypothetically grouped according to a second modification of the embodiment.

Fig. 10 is a diagram illustrating a plurality of the second concave reflection mirror components in a second fly's-eye optical system, the second concave reflection mirror components being hypothetically grouped according to the second modification of the embodiment.

Fig. 11 is a diagram illustrating a first component group of the first fly's-eye optical system, which includes twenty-three first concave reflection mirror components adjacent to each other according to the second modification.

Fig. 12 is a diagram illustrating, in the second modification, that light passing through the i-th first concave reflection mirror component in the first component group of the first fly's-eye optical system enters the second concave reflection mirror components in an i-th component group of the second fly's-eye optical system.

Fig. 13 is a diagram illustrating, in the second modification, that light passing through the first concave reflection mirror component in a j-th component group of the first fly's-eye optical system is incident to a j-th second concave reflection mirror component in the first component group of the second fly's-eye optical system.

Fig. 14 is a diagram illustrating, in a second comparative example, that a plurality of the first concave reflection mirror components of the first fly's-eye optical system are hypothetically grouped into six groups.

Fig. 15 is a diagram illustrating, in the second comparative example, that a plurality of the second concave reflection mirror components of the second fly's-eye optical system are hypothetically grouped into six groups.

Fig. 16 is a diagram illustrating, in a third modification, that a plurality of the first concave reflection mirror components of the first fly's-eye optical system are hypothetically grouped.

Fig. 17 is a diagram illustrating, in the third modification, that a plurality of the second concave reflection mirror components of the second fly's-eye optical system are hypothetically grouped.

Fig. 18 is a diagram illustrating, in the third modification, that the light passing through the first concave reflection mirror component in a j-th component group of the first fly's-eye optical system is incident to a j-th second concave reflection mirror component in the first component group of the second fly's-eye optical system.

Fig. 19 is a diagram illustrating an evaluating value H and a situation that sixteen first optical components are arbitrarily selected in the first fly's-eye optical system.

Fig. 20 is a diagram illustrating an example in that the positions of the second optical components, into which the light from the sixteen first optical components is incident, are distributed in the component groups.

Fig. 21 is a diagram illustrating an example in that the positions of the second optical components, into which the light from the sixteen first optical components is incident, are not dispersed and are concentrated in one component group.

Fig. 22 is a diagram illustrating an example in that the positions of the second optical components, into which the light from the sixteen first optical components is incident, are moderately dispersed and are concentrated in two component groups.

Fig. 23 is a flowchart illustrating a process for manufacturing a semiconductor device, such as a micro-device.

DESCRIPTION OF REFERENCE CHARACTERS

| | |
|---|---|
| 1 | laser plasma light source |
| 2 | illumination optical system |
| 5 | mask stage |
| 7 | wafer stage |
| 11 | laser source |
| 13 | gaseous target |
| 14 | nozzle |
| 15 | elliptic reflection mirror |
| 18a, 18b | fly's-eye optical system |
| 21 | field stop |
| M | mask |
| PL | projection optical system |
| ER | static exposure region |

BEST MODE FOR CARRYING OUT THE INVENTION

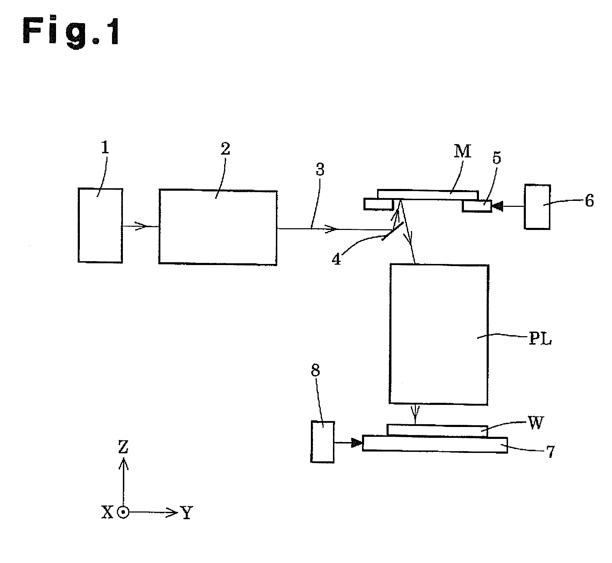

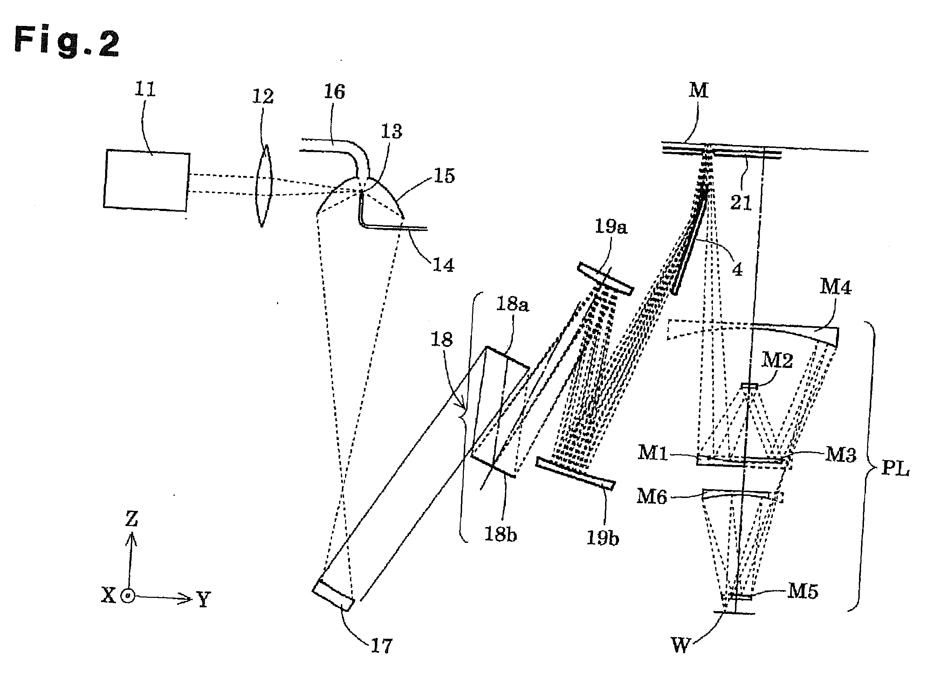

Embodiments will be described with references to the attached drawings. Fig. 1 illustrates an exposure apparatus 10 according to an embodiment. Fig. 2 illustrates a light source 1, an illumination optical system 2, and a projection optical system PL shown in Fig. 1. In Fig. 1, Z-axis may be established along an optical axial direction of projection optical system PL, i.e., a normal direction of a wafer W, which may be a photosensitive substrate; Y-axis may be established along a direction perpendicular to Z-axis and tangential to a light receiving surface of wafer W; and X-axis may be established along a direction perpendicular to Y-axis and Z-axis.

Referring to Fig. 1, the exposure apparatus of the present embodiment may include a light source 1, which may include a laser plasma light source, for supplying exposure light. Light emitted from the light source 1 enters an illumination optical system 2 via a wavelength selection filter (not shown). The wavelength selection filter may selectively transmit light with a predetermined wavelength (13.4 nm or 11.5 nm, for example) and shield light of other wavelengths. A reflection mask (reticle) M having a pattern to be transferred is irradiated by EUV light 3 passed through the wavelength selection filter, illumination optical system 2, and a planar reflection mirror 4 which acts as a light path deflection mirror.

The mask M may be held by a mask stage 5 movable along Y-direction so that a pattern plane of the mask M extends along the XY-plane. Mask stage 5 may be configured so that its movement is measurable by a laser interferometer 6. Light from the pattern of the illuminated mask M may form a mask pattern image on a wafer W, which may be a photosensitive substrate, via a reflection type projection optical system PL. That is, on wafer W, a circular-arc static exposure region, or an effective exposure region, may be formed symmetrically about Y-axis, as will be described later.

The wafer W may be held by a wafer stage 7, which is two-dimensionally movable in X-direction and Y-direction, so that its exposure plane extends along the XY-plane. The wafer stage 7, in the same way as the mask stage 5, may be configured so that its movement is measurable by a laser interferometer 8. In such a manner, while the mask stage 5 and wafer stage 7 are moved along Y-direction, i.e., while the mask M and wafer W are moved along Y-direction relatively to the projection optical system PL, by performing scanning exposure, the pattern of the mask M may be transferred onto a rectangular shot region of the wafer W.

At this time, When the projection magnification (transfer magnification) is a quarter, for example, synchronous scanning may be performed by setting the moving speed of the wafer stage 7 at a quarter of that of mask stage 5. Also, by repeating the scanning exposure while the wafer stage 7 is two-dimensionally moved along the X-direction and Y-direction, the pattern of the mask M may be sequentially transferred onto each shot region of the wafer W.

Referring to Fig. 2, the light source 1 shown in Fig. 1 may include a laser source 11, a condenser lens 12, a nozzle 14, and a duct 16. Light (non-EUV light) emitted from the laser source 11 may be condensed onto a gaseous target 13 via the condenser lens 12. A high-pressure gas, such as xenon (Xe), may be supplied from the nozzle 14, and the gas discharged from nozzle 14 may form the gaseous target 13. The gaseous target 13 may be converted into plasma by the energy of condensed laser light so as to emit EUV light. In addition, the gaseous target 13 may be positioned at a first focal point of an elliptic reflection mirror 15.

Thus, the EUV light radiated from the light source 1 is condensed onto a second focal point of the elliptic reflection mirror 15. On the other hand, the gas that has completed light emission may be drained via the duct 16 and led outside. EUV light condensed onto the second focal point of elliptic reflection mirror 15 may be substantially collimated through a concave reflection mirror 17 and led to an optical integrator 18 including a pair of fly's-eye optical systems 18a and 18b. The configurations and effects of the first fly's-eye optical system 18a and second fly's-eye optical system 18b will be described later.

Thus, in the vicinity of an exit surface of the optical integrator 18, i.e., in the vicinity of a reflection surface of second fly's-eye optical system 18b, a substantial planar light source having a predetermined shape may be formed. The substantial planar light source herein is formed at the position of an exit pupil of the illumination optical system 2. Light from the substantial planar light source exits the illumination optical system 2 via a condenser optical system 19 including a convex reflection mirror 19a and a concave reflection mirror 19b. Then, with the condenser optical system 19, the above-mentioned "substantial planar light source" may be projected to an exit pupil of projection optical system PL. That is, the "substantial planar light source" may be conjugated with an entrance pupil of projection optical system PL.

Light from the illumination optical system 2, after being deflected by the planar reflection mirror 4, may form a circular-arc illumination region on the mask M via a circular-arc opening (light transmission part) of a field stop 21 arranged substantially in parallel with and adjacent to the mask M. In such a manner, the light source (11-16), the illumination optical system 2, the planar reflection mirror 4, and the field stop 21 constitute an illumination system for Koehler-illuminating the mask M having a predetermined pattern.

Light from the illuminated pattern of the mask M may form a mask-pattern image on the circular-arc static exposure region via the projection optical system PL. The projection optical system PL may include a first reflection imaging optical system for forming intermediate images of the pattern of mask M and a second reflection imaging optical system for forming images of the intermediate images of the mask pattern (secondary images of the pattern of the mask M) on the wafer W. The first reflection imaging optical system may include four reflection mirrors M1 to M4, and the second reflection imaging optical system may include two reflection mirrors M5 and M6. The projection optical system PL may be telecentric toward a wafer (on the image side).

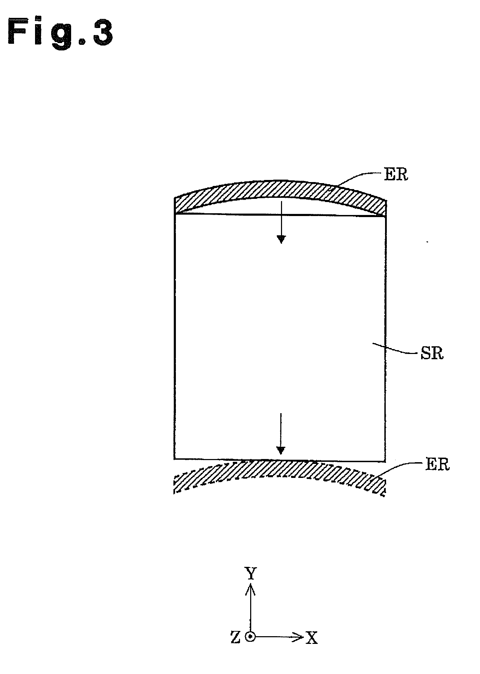

Fig. 3 schematically illustrates a one-time scanning exposure according to one embodiment. Referring to Fig. 3, a circular-arc static exposure region (an effective exposure region) ER may be formed symmetrically about the Y-axis so as to correspond to a circular-arc effective imaging region and an effective field of the projection optical system PL. The circular-arc static exposure region ER may move from a scanning start position, shown in solid lines in Fig. 3, to a scanning finish position, shown in broken lines in Fig. 3, when the pattern of mask M is transferred onto a rectangular one-shot region SR of wafer W by the one-time scanning exposure.

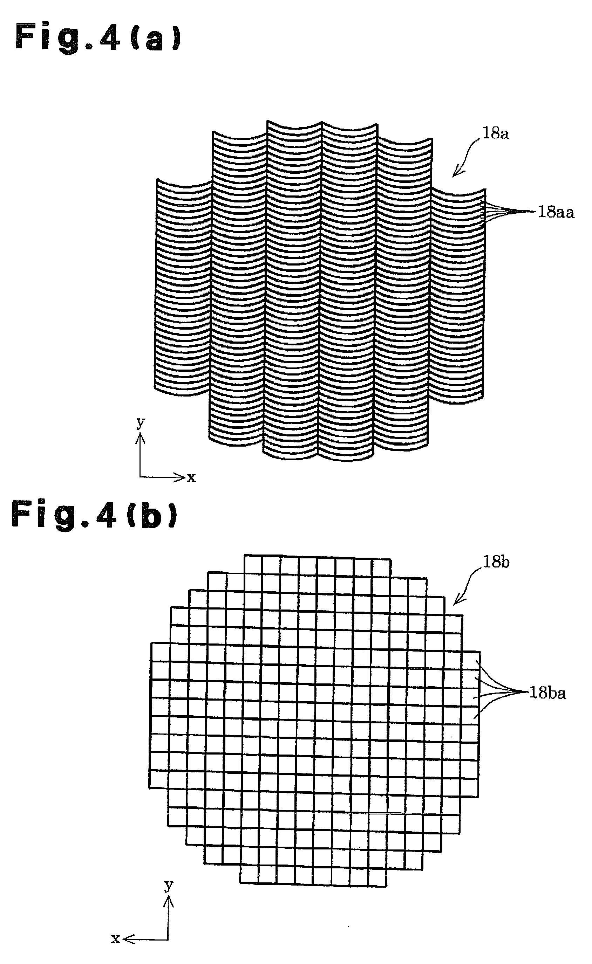

Fig. 4 illustrates an optical integrator 18 according to one embodiment. The optical integrator 18 may include a first fly's-eye optical system 18a comprising a plurality of first concave reflection mirror components (first optical components) 18aa juxtaposed as shown in Fig. 4(a), and a second fly's-eye optical system 18b comprising a plurality of second concave reflection mirror components (second optical components) 18ba juxtaposed in one-to-one correspondence to the first concave reflection mirror components 18aa, as shown in Fig. 4(b). Hereinafter, juxtaposition means that the mirror components 18aa and 18ba are so arranged that light incident in the fly's-eye optical systems 18a and 18b may be divided into partial beams.

In Fig. 4(a), x-direction may be established corresponding to the X-direction on an incidence plane of fly's-eye optical system 18a, and y-direction may be established corresponding to a direction perpendicular to the x-direction on the incidence plane of fly's-eye optical system 18a. Similarly, in Fig. 4(b), x-direction may be established corresponding to the X-direction on a incidence plane of fly's-eye optical system 18b, and y-direction may be established corresponding to a direction perpendicular to the x-direction on the incidence plane of fly's-eye optical system 18b. Also, in Fig. 4, for clarity of illustration, concave reflection mirror components 18aa and 18ba of fly's-eye optical systems 18a and 18b are shown to include less mirrors than actual.

Specifically, the fly's-eye optical system 18a, as shown in Fig. 4(a), is configured by densely arranging first concave reflection mirror components 18aa, each having a circular arc external shape, in lengthwise and crosswise directions. The reason for the first concave reflection mirror component 18aa to have the circular arc external shape, as described above, is that the circular arc illumination region is formed on the mask M corresponding to the circular-arc effective imaging region and the effective field of projection optical system PL. Further, the circular-arc static exposure region ER is formed on the wafer W corresponding to the circular arc illumination region formed on the mask M.

The fly's-eye optical system 18b, as shown in Fig. 4(b), is configured by densely arranging the second concave reflection mirror components 18ba, each having a rectangular external shape close to a square, in lengthwise and crosswise directions. The reason for second concave reflection mirror component 18ba to have the rectangular external shape close to a square is that a substantially circular small light source is formed on the surface of second concave reflection mirror component 18ba or in the vicinity thereof.

The reason why the entrance surface of the fly's-eye optical system 18a has a substantially circular external shape is that the cross-sectional shape of a light beam incident in the optical integrator 18 (i.e., the light beam incident in first fly's-eye optical system 18a) is substantially circular for improving the illumination efficiency. Also, the reason why the exit surface of the fly's-eye optical system 18b is substantially circular in external shape is that the external shape of light intensity distribution (the substantially planar light source) formed on the exit pupil in the vicinity of the exit surface of optical integrator 18 (i.e., the exit surface of second fly's-eye optical system 18b) is substantially circular.

In one embodiment, the light incident in optical integrator 18 may be wavefront-divided by the first concave reflection mirror components 18aa in the first fly's-eye optical system 18a. The light beam reflected from each first concave reflection mirror component 18aa may enter the corresponding second concave reflection mirror component 18ba in the second fly's-eye optical system 18b. With the light beam reflected from each second concave reflection mirror component 18ba, the circular arc illumination region on mask M is illuminated in an overlapping manner by the condenser optical system 19, which acts as a light guide optical system.

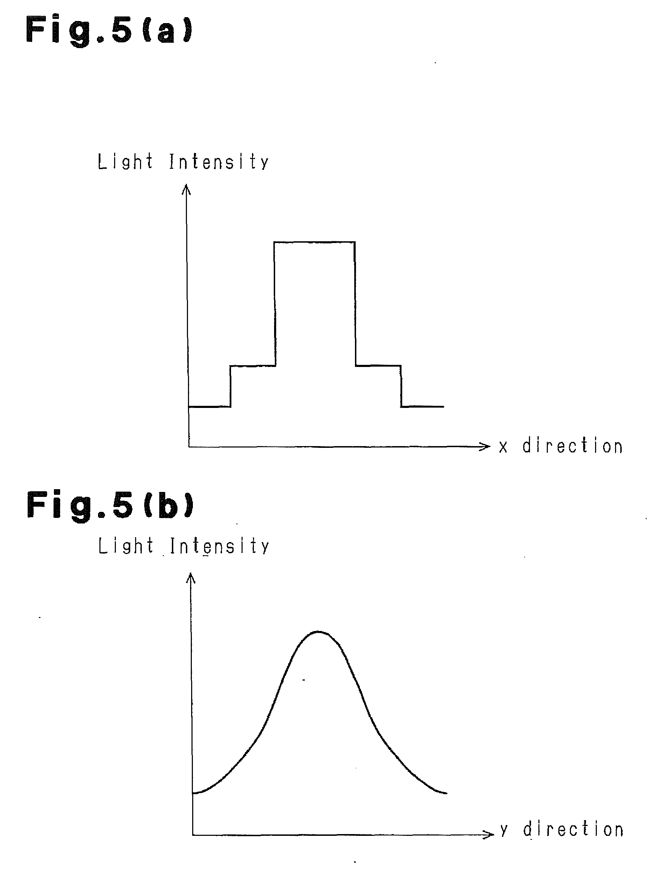

Fig. 5 illustrates a light intensity profile formed on the exit pupil of a conventional illumination optical apparatus, in which Fig. 5(a) shows the profile in x-direction and Fig. 5(b) shows the profile in y-direction. As described above, the light beam incident in the optical integrator 18 is wavefront-divided by the first concave reflection mirror components 18aa elongated along the x-direction and having circular arc external shapes. That is, as understood with reference to Fig. 4(a), the number of wavefront-divided pieces of optical integrator 18 in the x-direction is considerably smaller than that in the y-direction.

In a conventional technique, the correspondence relationship between the first concave reflection mirror components 18aa of the first fly's-eye optical system 18a and the second concave reflection mirror components 18ba of the second fly's-eye optical system 18b is not especially taken into account. Hence, when the light having a convex shaped light intensity distribution substantially symmetrical about the optical axis or the central axis (the distribution having the intensity maximum at the center decreasing toward the periphery) is incident in the optical integrator 18, the profile of pupil intensity distribution obtained from the conventional technique, as shown in Fig. 5(b), is curved to continuously change in the y-direction, along which the number of wavefront-divided pieces is comparatively large. Whereas, in the x-direction, along which the number of wavefront-divided pieces is comparatively small, the profile, as shown in Fig. 5 (a), may change discontinuously in a step-wise manner. That is, in the conventional technique, because the pupil intensity distribution is not substantially rotationally symmetrical about the optical axis or the central axis, the line width of the image formed on wafer W may differ corresponding to the direction of the pattern, so that the performance of the manufactured integrated circuit is apt to deteriorate.

According to one embodiment, a large number of first concave reflection mirror components 18aa may be hypothetically grouped, so that first fly's-eye optical system 18a may include an N number of component groups, each group comprising an N number of first concave reflection mirror components adjacent to each other. Similarly, a large number of second concave reflection mirror components 18ba may be hypothetically grouped, so that second fly's-eye optical system 18b may include an N number of component groups, each group comprising an N number of second concave reflection mirror components adjacent to each other. Then, a correspondence relationship between the plurality of first concave reflection mirror components 18aa and plurality of second concave reflection mirror components 18ba may be established, so that the light that has passed through the i-th component group (i=1 to N) of the first concave reflection mirror components of the first fly's-eye optical system 18a enters the i-th component group (i=1 to N) of the second concave reflection mirror components of the second fly's-eye optical system 18b.

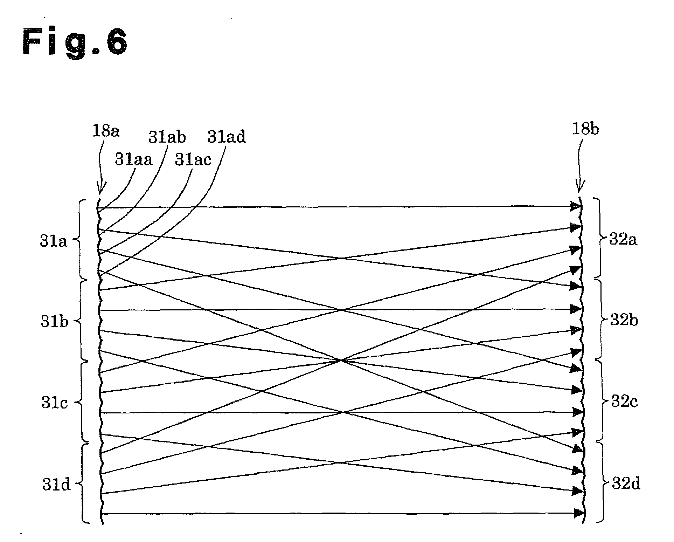

The correspondence relationship between the plurality of first concave reflection mirror components 18aa and the plurality of second concave reflection mirror components 18ba will be described below with reference to a simplified one-dimensional model, as shown in Fig. 6. In the one-dimensional model shown in Fig. 6, the first fly's-eye optical system 18a may include four component groups adjoined and arranged along a vertical direction of Fig. 6, each group including the first concave reflection mirror components. Also, the second fly's-eye optical system 18b, in the same way as in the first fly's-eye optical system 18a, may include four component groups adjoined and arranged along the vertical direction, each group including the second concave reflection mirror components.

When a first component group 31a of the first fly's-eye optical system 18a is noted, the light that has passed through a first concave reflection mirror component 31aa of the first component group 31a may enter a second concave reflection mirror component 32aa of a first component group 32a of the second fly's-eye optical system 18b. The light that has passed through a first concave reflection mirror component 31ab of the first component group 31a may enter a second concave reflection mirror component 32ba of a second component group 32b of the second fly's-eye optical system 18b.

The light that has passed through a first concave reflection mirror component 31ac of the first component group 31a may enter a second concave reflection mirror component 32ca of a third component group 32c of the second fly's-eye optical system 18b. The light that has passed through a first concave reflection mirror component 31ad of the first component group 31a may enter a second concave reflection mirror component 32da of a fourth component group 32d of the second fly's-eye optical system 18b.

Similarly, with regard to a second component group 31b, a third component group 31c, and a fourth component group 31d, the light that has passed through first concave reflection mirror components of the second component group 31b, third component group 31c, and fourth component group 31d may enter, as shown in Fig. 6, the second concave reflection mirror components of the first to fourth component groups 32a to 32d of the second fly's-eye optical system 18b, respectively. In contrast to the one-dimensional model shown in Fig. 6, the optical integrator 18, in practice, may include an N number of component groups in the first fly's-eye optical system 18a and an N number of component groups in the second fly's-eye optical system 18b, which may be arranged two dimensionally. Further, N concave reflection mirror components of each component group may also be arranged two dimensionally.

As described above, according to one embodiment, a large number of partial light formed by wavefront-dividing the beam incident in first fly's-eye optical system 18a may be thoroughly rearranged and transferred to the second fly's-eye optical system 18b. In other words, when the partial light is transferred from the first concave reflection mirror component 18aa on the entrance side of the optical integrator 18 to the second concave reflection mirror component 18ba on the exit side, the partial light group reflected from the same group (the same component group) of first fly's-eye optical system 18a on the entrance side is guided to positions dispersed on the entrance surface of second fly's-eye optical system 18b without being transferred to the same group (the same component group) of second fly's-eye optical system 18b on the exit side.

In such a manner, according to one embodiment, when the light having a convex shape light intensity distribution substantially symmetrical about the optical axis or an axis such as the central axis enters optical integrator 18, this light having the convex shape light intensity distribution is wavefront-divided by a number of the first concave reflection mirror components 18aa in the first fly's-eye optical system 18a. Each partial light wavefront-divided may be rearranged substantially at random, so as to arrive at each second concave reflection mirror component 18ba of the second fly's-eye optical system 18b. Consequently, the profile of the pupil intensity distribution obtained according to one embodiment, as shown in Fig. 5(b), is curved along an arbitrary direction passing through the axis (i.e., a radial direction), so as to be rotationally symmetrical with respect to the axis.

As described above, in the illumination optical apparatus 2 according to one embodiment, the mask M (or wafer W by extension) can be illuminated under a desired illumination condition by forming a light intensity distribution rotationally symmetrical with respect to an axis at the exit pupil. Also, in the exposure apparatus 10 according to one embodiment, the exposure can preferably be operated by forming the light intensity distribution rotationally symmetrical with respect to an axis at the exit pupil and using the illumination optical apparatus 2 to illuminate the mask M under a desired illumination condition. Specifically, on the basis of the pupil intensity distribution having a profile substantially rotationally symmetrical with respect to an axis, a vertical pattern, a horizontal pattern, and a slanting direction pattern may have a uniform line width.

As described above, because the light intensity distribution being substantially symmetrical with respect to an axis is formed on the exit pupil, the partial light group reflected from the same group (the same component group) of the first fly's-eye optical system 18a on the entrance side may be led to positions dispersed on the incident surface of the second fly's-eye optical system 18b. However, the invention is not limited thereto. A first modification may be made in that the partial light group reflected from the same group (the same component group) of the first fly's-eye optical system 18a on the entrance side is dispersed and led to the corresponding group (the corresponding component group).

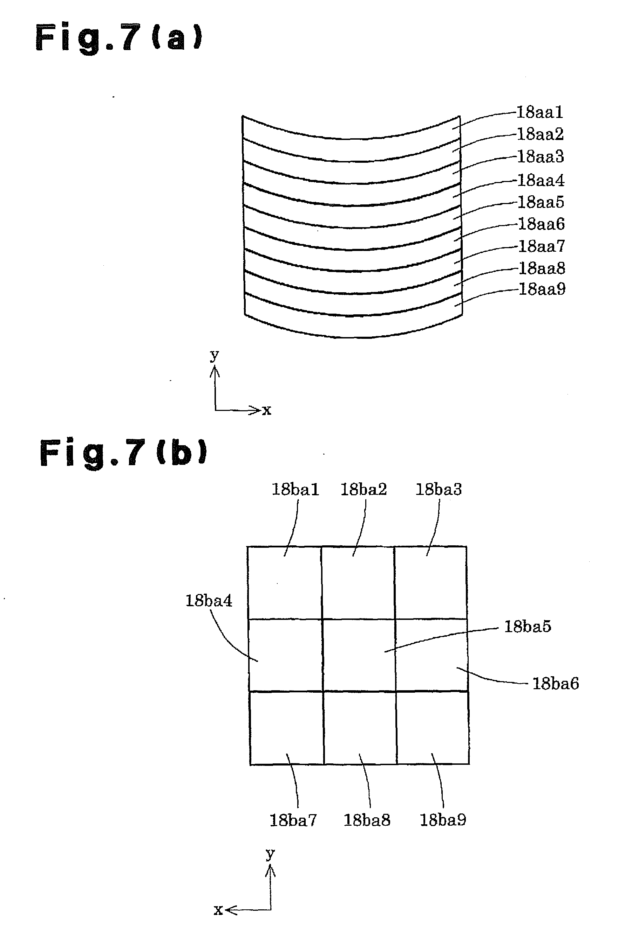

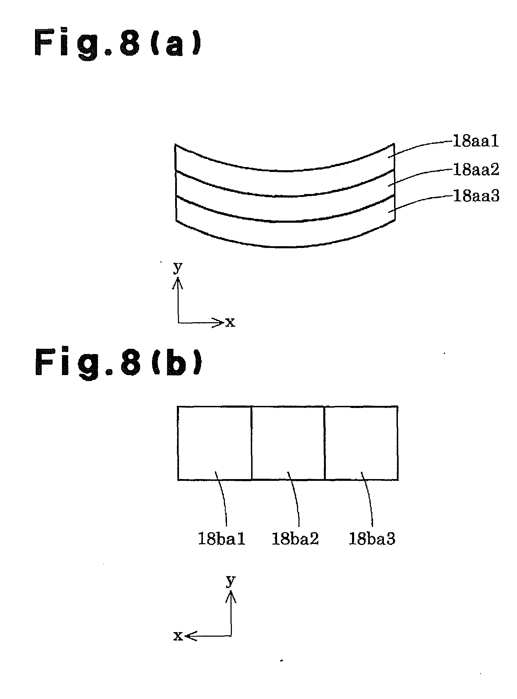

Fig. 7 illustrates the correspondence relationship between a plurality of first concave reflection mirror components and a plurality of second concave reflection mirror components according to the first modification. In Fig. 7(a), nine adjoining first concave reflection mirror components 18aa1 to 18aa9 arranged in the y-direction are illustrated. In Fig. 7(b), nine adjoining second concave reflection mirror components 18ba1 to 18ba9, which are arranged in lengthwise and crosswise directions (or arranged in a three-by-three array), are illustrated. Also, Fig. 8 illustrates a correspondence relationship between a plurality of first concave reflection mirror components and a plurality of second concave reflection mirror components according to the first modification. In Fig. 8(a), three adjoining first concave reflection mirror components 18aa1 to 18aa3 arranged in the y-direction are illustrated. In Fig. 8(b), three adjoining second concave reflection mirror components 18ba1 to 18ba2 arranged in the x-direction are illustrated.

According to the first modification of the present embodiment, a large number of first concave reflection mirror components 18aa may be hypothetically grouped, so that first fly's-eye optical system 18a may include an N number of component groups, each group comprising r first concave reflection mirror components adjacent to each other. Similarly, a number of second concave reflection mirror components 18ba may be hypothetically grouped, so that the second fly's-eye optical system 18b may include an N number of component groups, each group comprising an n number of second concave reflection mirror components adjacent to each other.

Then, a correspondence relationship between the plurality of first concave reflection mirror components 18aa and plurality of second concave reflection mirror components 18ba may be established, so that the light that has passed through the i-th component group (i=1 to N) of the first concave reflection mirror components of the first fly's-eye optical system 18a may enter the i-th component group (i=1 to N) of the second concave reflection mirror components of the second fly's-eye optical system 18b. Furthermore, the hypothetical grouping of a plurality of first concave reflection mirror components 18aa and a plurality of second concave reflection mirror components 18ab may be established, so that each component group in the first fly's-eye optical system 18a and each component group in the second fly's-eye optical system 18b is inscribed with a square or a rectangle close to a square.

Namely, according to the first modification, a typical component group in the first fly's-eye optical system 18a, as shown in Fig. 7(a), may include nine circular arc adjoining first concave reflection mirror components 18aa1 to 18aa9 arranged in the y-direction and having an external shape inscribed with a substantial square. Also, the corresponding component group in the second fly's-eye optical system 18b, as shown in Fig. 7(b), may include $3 \times 3 = 9$ rectangular second concave reflection mirror components 18ba1 to 18ba9, which are inscribed with each other and having an external shape inscribed with a substantial square. In addition, the correspondence relationship between the nine circular arc first concave reflection mirror components 18aa1 to 18aa9 and the nine rectangular second concave reflection mirror components 18ba1 to 18ba9 may be appropriately varied depending on the component group.

Hence, the light wavefront-divided by one component group having a substantially square external shape in the first fly's-eye optical system 18a may enter one component group having a substantially square external shape in the second fly's-eye optical system 18b, so that the pupil intensity distributions formed on partial regions corresponding to rectangular second concave reflection mirror components 18ba1 to 18ba9 may be uniform to some extent due to the wavefront-dividing effect. As a result, in the profile of the pupil intensity distribution previously obtained according to the first modification, as shown in Fig. 5(a), the intensity discontinuously may change step-wise in the x-direction as well as in the y-direction.

That is, according to the first modification, the profile of the pupil intensity distribution is not substantially rotationally symmetrical with respect to an axis, but is substantially symmetrical about the x-direction and y-direction and identical in shape (shaped stepwise substantially in the same manner). In such a manner, according to the first modification, on the basis of the pupil intensity distribution having a profile substantially symmetrical with respect to two perpendicular directions (x-direction and y-direction) and substantially identical in shape, the vertical pattern and horizontal pattern can have a uniform line width.

However, in the first modification, the line widths of the pattern in the oblique direction cannot be uniform. In view of the equalization of the pattern line widths, one may prefer the above-described embodiment rather than the first modification shown in Fig. 7. However, according to the embodiment, every concave reflection mirror component must radically change the direction of the light. Thus, the concave reflection mirror components should tilt in very different directions. Thus, according to the embodiment described above, a relatively large step is generated between two adjoining concave reflection mirror components in comparison with the first modification in some situations, so that the light amount loss may be generated in some cases.

On the other hand, according to a first comparative example, a typical component group in the first fly's-eye optical system 18a, as shown in Fig. 8(a), may include three circular arc adjoining first concave reflection mirror components 18aa1 to 18aa3 arranged in the y-direction to have a substantially rectangular external shape elongated along the x-direction. Also, the corresponding component group in the second fly's-eye optical system 18b, as shown in Fig. 8(b), may include three rectangular second concave reflection mirror components 18ba1 to 18ba3 arranged in the x-direction, which contact with each other to have a rectangular external shape elongated along the x-direction.

In this case, the light wavefront-divided by one component group having a rectangular external shape elongated along x-direction in the first fly's-eye optical system 18a may enter one component group having a rectangular external shape elongated along the x-direction in the second fly's-eye optical system 18b, so that the pupil intensity distributions formed on partial regions corresponding to the three rectangular second concave reflection mirror components 18ba1 to 18ba3 are uniform to some extent due to the wavefront dividing effect.

As a result, in the profile of the pupil intensity distribution obtained according to the first comparative example, as shown in Fig. 5(a), the intensity discontinuously changes step-wise in the x-direction and, as shown in Fig. 5(b), is curved to continuously change in the y-direction. That is, according to the first comparative example, because the shape of the pupil intensity distribution profile along x-direction is substantially different from that along y-direction, the line widths cannot be uniform in the vertical pattern and the horizontal pattern.

As is apparent from the first modification and the first comparative example, in order to obtain uniform line widths in the vertical pattern and the horizontal pattern by forming the pupil intensity distribution having a profile substantially symmetrical in two perpendicular directions and substantially identical in shape, the lengthwise and crosswise ratio of the rectangle circumscribing each component group in the first fly's-eye optical system 18a and each component group in the second fly's-eye optical system 18b is important, and the circumscribing rectangular shape is preferably close to a square. Generally, in a rectangle (broadly understood as including a square) circumscribing each component group, When the ratio of a longer side to a shorter side is 1/2 or more, the desired effects may be obtained for uniform line widths.

As described above, concave reflection mirror components may be grouped so that the first fly's-eye optical system 18a includes an N number of component groups, each group including an N number of first concave reflection mirror components, and the second fly's-eye optical system 18b includes an N number of component groups, each group including an N number of second concave reflection mirror components. However, the invention is not limited thereto. It should be appreciated that a second modification may be made in that the concave reflection mirror components may be grouped so that first fly's-eye optical system 18a includes an N number of component groups, each group including an n number of first concave reflection mirror components, and the second fly's-eye optical system 18b includes an N number of component groups, each group including an n number of second concave reflection mirror components so as to achieve a similar effect as the embodiment described above.

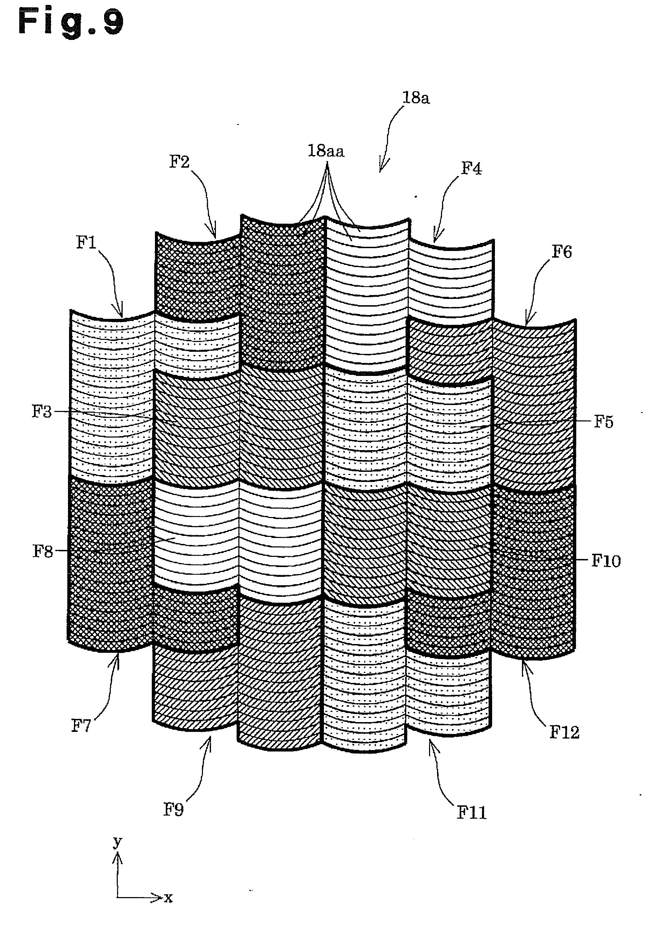

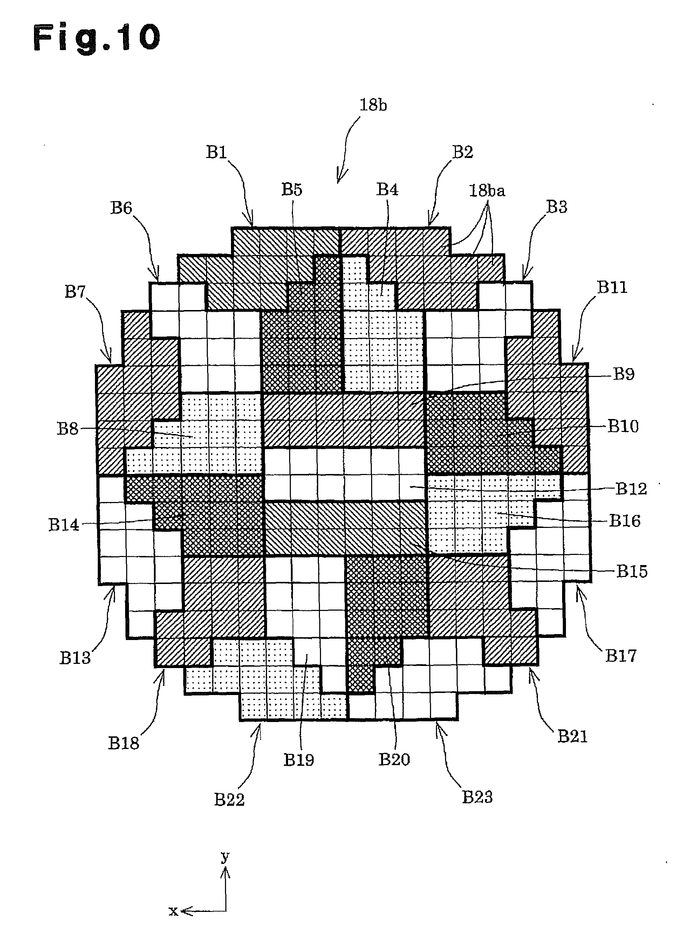

Specifically, according to the second modification, as shown in Fig. 9, 276 first concave reflection mirror components 18aa in total may be hypothetically grouped so that the first fly's-eye optical system 18a includes twelve component groups, each group including twenty-three first concave reflection mirror components, which are adjacent to each other. In Fig. 9, the j-th (j=1 to 12) component group is designated by reference character Fj. As shown in Fig. 10, 276 second concave reflection mirror components 18ba in total may be hypothetically grouped so that the second fly's-eye optical system 18b includes twenty-three component groups, each group including twelve second concave reflection mirror components, which are adjacent to each other. In Fig. 10, the i-th (i=1 to 23) component group is designated by reference character Bi.

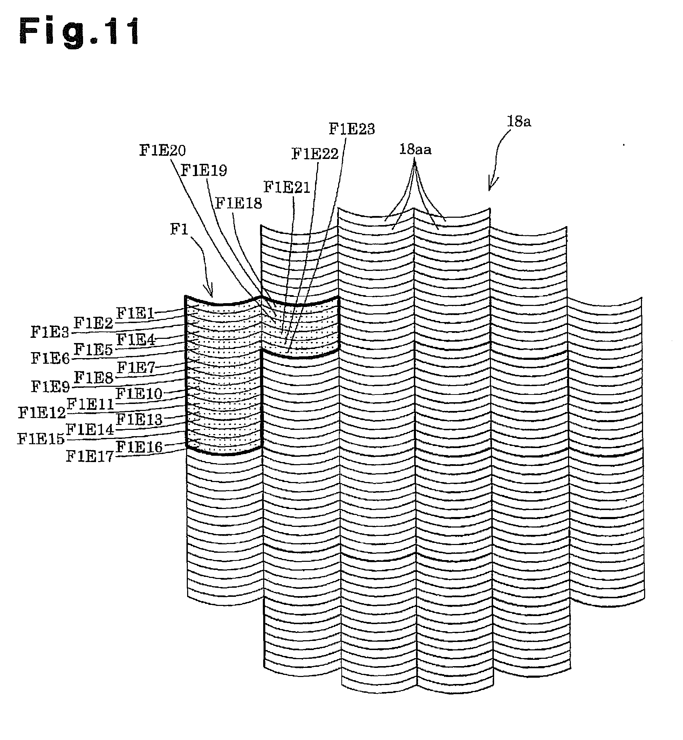

The corresponding relationship between the first concave reflection mirror components 18aa and second concave reflection mirror component 18ba, according to the second modification, will be described below by using a first component group F1 of the first fly's-eye optical system 18a and a first component group B1 of the second fly's-eye optical system 18b. The first component group F1 of the first fly's-eye optical system 18a, as shown in Fig. 11, may include twenty-three first concave reflection mirror components, which are adjacent to each other. In Fig. 11, the i-th (i=1 to 23) first concave reflection mirror component is designated by reference character F1Ei.

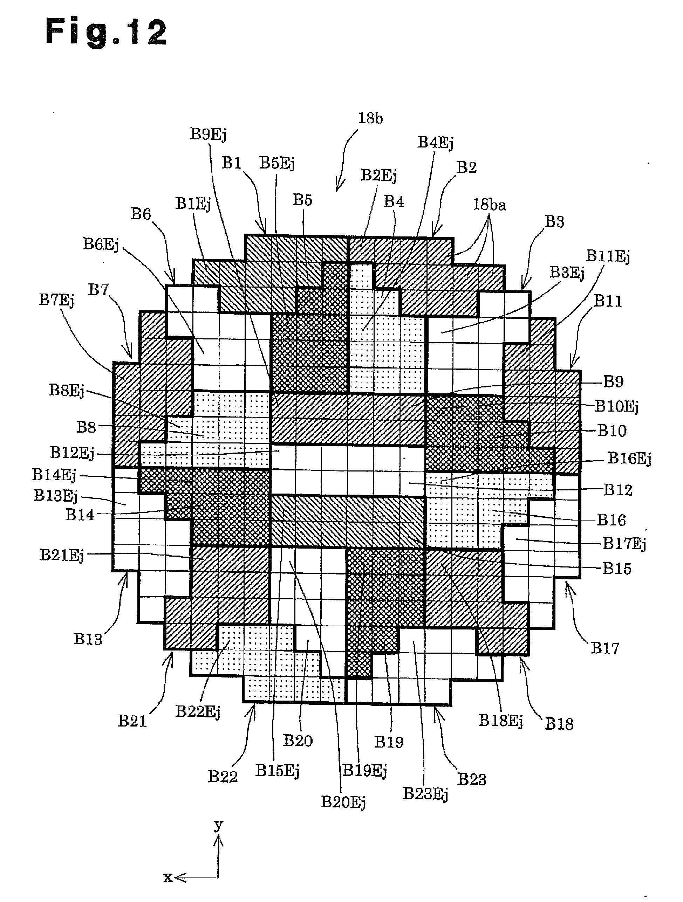

According to the second modification, with regard to first component group F1 of first fly's-eye optical system 18a, the corresponding relationship between the first concave reflection mirror components 18aa and second concave reflection mirror components 18ba may be established so that the light that has passed through the i-th (i=1 to 23) first concave reflection mirror component F1Ei of the component group F1 enters any second concave reflection mirror component of the i-th (i=1 to 23) component group B1 of the second fly's-eye optical system 18b. That is, the i-th (i=1 to 23) first concave reflection mirror component F1Ei of component group F1, as shown in Fig. 12, may correspond to any second concave reflection mirror component BiEj in the i-th (i=1 to 23) component group Bi of the second fly's-eye optical system 18b. Although not shown, with regard to the other component groups Fj (j=2 to 12) of the first fly's-eye optical system 18a, in the same way, the light that has passed through a i-th (i=1 to 23) first concave reflection mirror component FjEi of the component groups Fj many enter any second concave reflection mirror component of the i-th (i=1 to 23) component group Bi of the second fly's-eye optical system 18b.

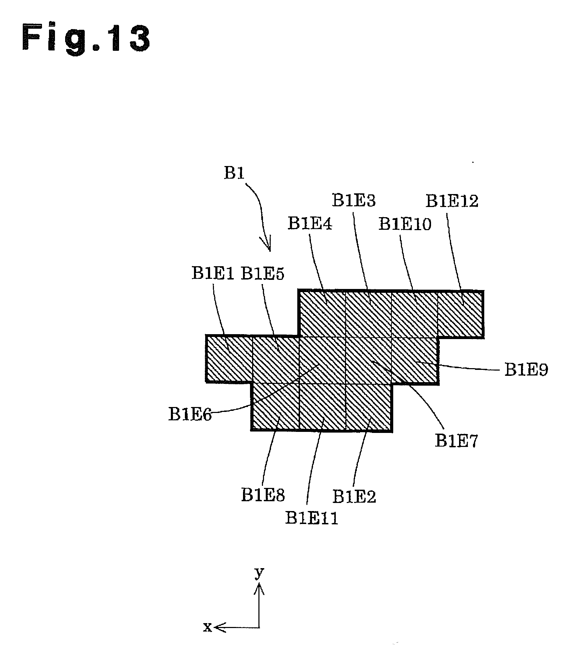

Therefore, as shown in Fig. 13, in the first component group B1 of the second fly's-eye optical system 18b, the light that has passed through any one of the first concave reflection mirror components FjEi of the j-th (j=1 to 12) component group Fj of the first fly's-eye optical system 18a is incident to the i-th (j=1 to 12) second concave reflection mirror component B1Ej of the component group B1. Similarly, although not shown, with regard to the other component groups Bi (i=2 to 23) of the second fly's-eye optical system 18b, the light that has passed through any one of the first concave reflection mirror components FjEi of the j-th (j=1 to 12) component group Fj of the first fly's-eye optical system 18a is incident to the j-th (j=1 to 12) second concave reflection mirror component BiEj of the component group Bi. In such a manner, the light from all the component groups of the first fly's-eye optical system 18a is incident to one component group of the second fly's-eye optical system 18b, so that the light intensity distribution becomes substantially constant between the component groups of the second fly's-eye optical system 18b.

As described above, when the partial light is transferred from the first concave reflection mirror component 18aa on the entrance side of the optical integrator 18 to the second concave reflection mirror component 18ba on the exit side, the partial light group reflected from the same component group of first fly's-eye optical system 18a on the entrance side may not be transferred to the same component group of the second fly's-eye optical system 18b on the exit side, but may be led to positions dispersed on the incident surface of the second fly's-eye optical system 18b. Consequently, the profile of the pupil intensity distribution obtained according to the second modification is curved along an arbitrary direction passing through the axis (i.e., a radial direction), as shown in Fig. 5(b), so as to be substantially rotationally symmetrical with respect to an axis in the same way as described above.

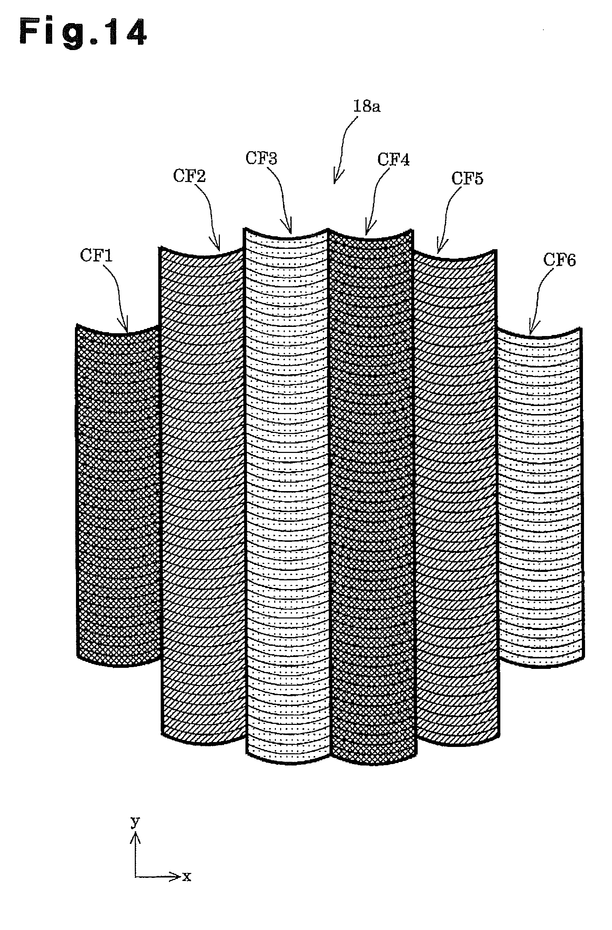

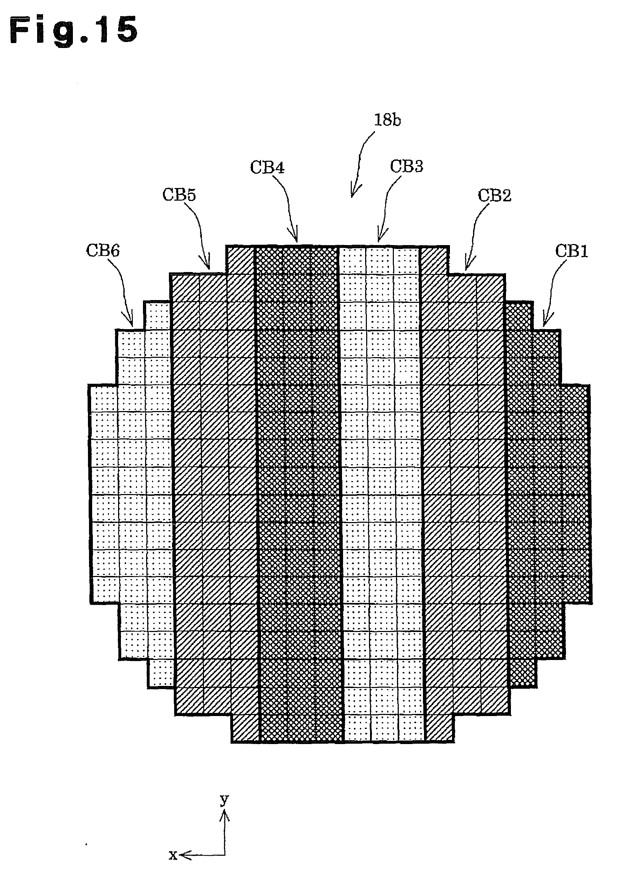

In the second comparative example corresponding to the second modification, a plurality of the first concave reflection mirror components in the first fly's-eye optical system 18a, as shown in Fig. 14, may be hypothetically grouped into six component groups CF1 to CF6, each having a strip-like external shape elongated in the y-direction. Also, a plurality of the second concave reflection mirror components in the second fly's-eye optical system 18b, as shown in Fig. 15, may be hypothetically grouped into six component groups CB1 to CB6, each having a strip-like external shape elongated in the y-direction corresponding to the component groups CF1 to CF6 in the first fly's-eye optical system 18a.

In the second comparative example, the light wavefront-divided by a plurality of the circular arc first concave reflection mirror components elongated in the x-direction included in component groups CF1 to CF6 of first fly's-eye optical system 18a may enter a corresponding plurality of the second concave reflection mirror components in the component groups CB1 to CB6 of the second fly's-eye optical system 18b. Therefore, in the profile of the pupil intensity distribution obtained from the second comparative example, as shown in Fig. 5(a), the intensity discontinuously changes step-wise in the x-direction, and as shown in Fig. 5(b), is curved to substantially continuously change in the y-direction.

In the second modification described above, the 276 first concave reflection mirror components 18aa in total in the first fly's-eye optical system 18a may be hypothetically grouped, and the 276 second concave reflection mirror components 18ba in total in the second fly's-eye optical system 18b may be hypothetically grouped. However, the invention is not limited thereto. A third modification may be made in that most of the first concave reflection mirror components 18aa in the first fly's-eye optical system 18a are hypothetically grouped, and almost of the second concave reflection mirror components 18ba in second fly's-eye optical system 18b are hypothetically grouped so as to achieve the same effects as the embodiments described above.

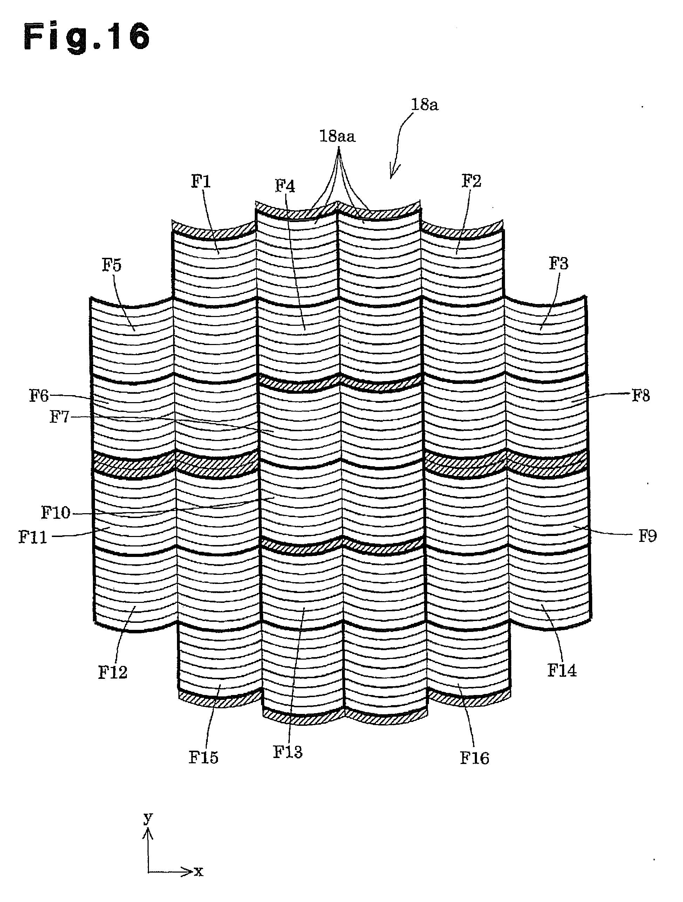

Specifically, in the third modification, as shown in Fig. 16, 256 first concave reflection mirror components 18aa in total may be hypothetically grouped so that first fly's-eye optical system 18a may include sixteen component groups, each group including sixteen first concave reflection mirror components, which are adjacent to each other. In Fig. 16, a region surrounded by a thick line corresponds to one component group; the j-th (j=1 to 12) component group is designated by reference character Fj; and twenty of the first concave reflection mirror components 18aa, which do not belong to any component group, are hatched.

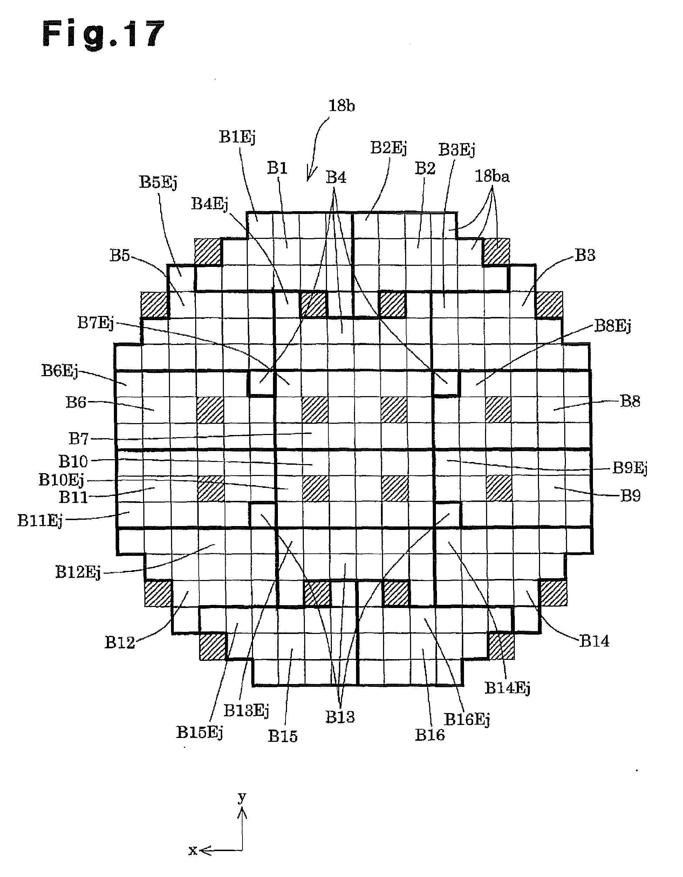

As shown in Fig. 17, 256 second concave reflection mirror components 18ba in total may be hypothetically grouped so that the second fly's-eye optical system 18b includes sixteen component groups, each group including sixteen second concave reflection mirror components, which are adjacent to each other. In Fig. 17, a region surrounded by a thick line corresponds to one component group; the i-th (i=1 to 16) component group is designated by reference character Bi; and twenty of the second concave reflection mirror components 18ba, which do not belong to any component group, are hatched. Component groups B4 and B13 may include second concave reflection mirror components 18ba, which are not in contact with the side of second concave reflection mirror component 18ba. In this case, all second concave reflection mirror components 18ba in component groups B4 and B13 may also be referred to as being arranged adjacent to each other.

According to the third modification, with regard to the first component group F1 of the first fly's-eye optical system 18a, the light that has passed through the i-th (i=1 to 16) first concave reflection mirror component F1Ei of the component group F1 may enter any second concave reflection mirror component of the i-th (i=1 to 16) component group B1 of the second fly's-eye optical system 18b. That is, the i-th (i=1 to 16) first concave reflection mirror component F1Ei of the component group F1, as shown in Fig. 17, may correspond to any one of the second concave reflection mirror components BiEj in the i-th (i=1 to 16) group Bi of the second fly's-eye optical system 18b. Similarly, although not shown, with regard to the other component groups Fj (j=2 to 16) of the first fly's-eye optical system 18a, the light that has passed through the i-th (i=1 to 16) first concave reflection mirror component FjEi of the component groups Fj may enter any second concave reflection mirror component of the i-th (i=1 to 16) component group Bi of the second fly's-eye optical system 18b.

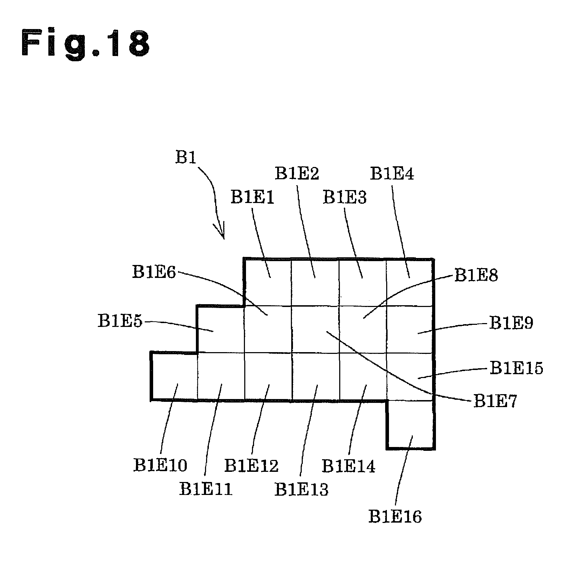

Therefore, as shown in Fig. 18, in the first component group B1 of the second fly's-eye optical system 18b, the light that has passed through any of the first concave reflection mirror components FjEi of the j-th (j=1 to 16) component group Fj of the first fly's-eye optical system 18a is incident to the j-th (j=1 to 16) second concave reflection mirror component B1Ej of the component group B1. Similarly, although not shown, with regard to the other component groups Bi (i=2 to 16) of the second fly's-eye optical system 18b, the light that has passed through any one of the first concave reflection mirror components FjEi of the j-th (j=1 to 16) component group Fj of the first fly's-eye optical system 18a is incident to the j-th (j=1 to 16) second concave reflection mirror component BiEj of the component group Bi. In such a manner, the light from all of the component groups in the first fly's-eye optical system 18a is incident to one component group of second fly's-eye optical system 18b, so that the light intensity distribution becomes substantially constant between the component groups of second fly's-eye optical system 18b.

Referring to Fig. 17, twenty of the second concave reflection mirror components 18ba, which are not grouped, are arranged in a separated state from each other. Hence, according to the third modification, even when the correspondence relationship between twenty of the first concave reflection mirror components 18aa, which are not grouped, and twenty of the second concave reflection mirror components 18ba is established, two partial light reflected from relative close positions in the first fly's-eye optical system 18a on the entrance side cannot enter a relatively close position in the second fly's-eye optical system 18b on the exit side.

According to the third modification, in the same way as described above, when the partial light is transferred from the first concave reflection mirror component 18aa on the entrance side of the optical integrator 18 to the second concave reflection mirror component 18ba on the exit side, the partial light group reflected from the same component group of the first fly's-eye optical system 18a on the entrance side may not be transferred to the same component group of the second fly's-eye optical system 18b on the exit side, but may be led to positions dispersed on the incident surface of the second fly's-eye optical system 18b. Consequently, the profile of the pupil intensity distribution obtained according to the third modification is curved along an arbitrary direction passing through the axis (i.e., a radial direction), as shown in Fig. 5(b), so as to be substantially rotationally symmetrical with respect to an axis in the same way as described above.

In the description above, a plurality of the first concave reflection mirror components of the first fly's-eye optical system are grouped into a plurality of the component groups and a plurality of the second concave reflection mirror components of the second fly's-eye optical system are grouped into a plurality of the component groups, and then, a corresponding relationship is established between the first concave reflection mirror components and the second concave reflection mirror components. However, various modifications may be made for establishing the correspondence relationship between the first concave reflection mirror components and the second concave reflection mirror components so that the profile of pupil intensity distribution is substantially rotationally symmetrical with respect to an axis or substantially symmetrical and substantially identical in shape in two perpendicular directions.

When a correspondence relationship is established on the basis of any technique between a plurality of the first optical components (the first concave reflection mirror components) in the first fly's-eye optical system and a plurality of the second optical components (the second concave reflection mirror components) in the second fly's-eye optical system, an evaluation value H will be described for evaluating the performance of this correspondence relationship that makes the profile of light intensity distribution in the exit pupil substantially rotationally symmetrical with respect to an axis or substantially symmetrical and substantially identical in shape with respect to two perpendicular directions.

In principle, the number of the first optical components of the first fly's-eye optical system and the number of the second optical components of the second fly's-eye optical system are equal to each other. Even When it is assumed that a dummy optical component or a measurement optical component were to be added to the fly's-eye optical system, the number of effective optical components for contributing to the illumination should be between the number of the first optical components and the number of the second optical components. Then, the number of the first optical components (or the number of the second optical components) is designated by a number m.

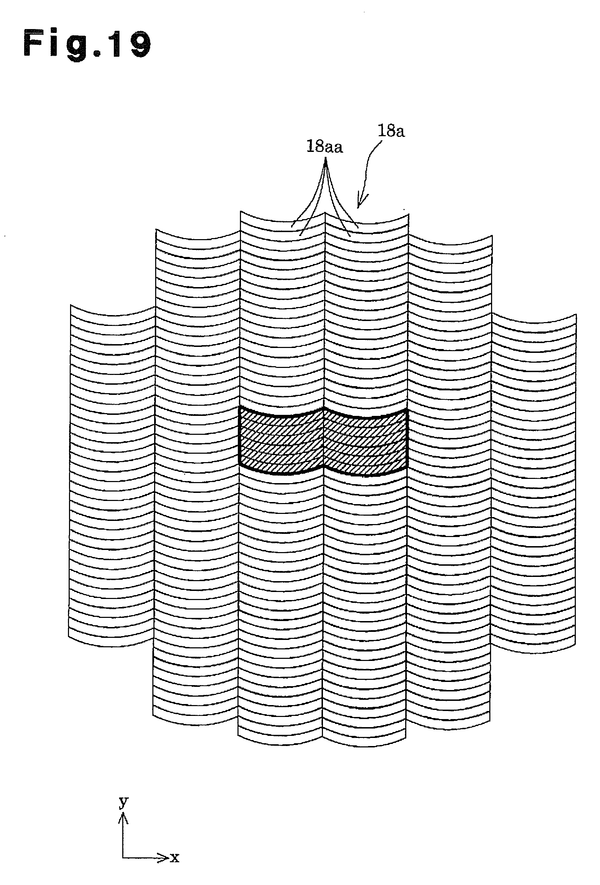

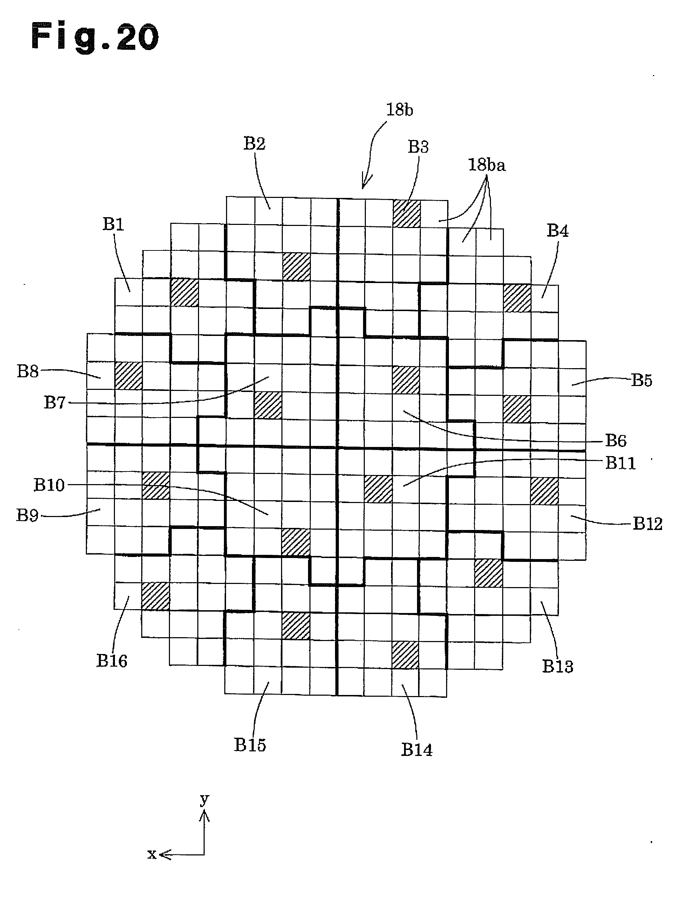

Specifically, the number m of first concave reflection mirror components 18aa included in first fly's-eye optical system 18a, shown in Fig. 19, is 276, and the number m of second concave reflection mirror components 18ba included in second fly's-eye optical system 18b, shown in Fig. 20, is also 276. An integer n herein is defined as n=Int {Sqrt (m)} (an integer obtained by rounding off decimal places of a square root of m), and it is assumed that in the first fly's-eye optical system 18a, there are r first optical components 18aa, which are adjacent to each other. For example, when number m is 276, integer n is 16. Hence, in Fig. 19, sixteen adjacent first optical components 18aa may be arbitrarily selected as an n number of first optical components 18aa, which are adjacent to each other and hatched.

Then, the 276 second optical components 18ba (m=276) in the second fly's-eye optical system 18b are hypothetically divided into sixteen component groups (n=16), so that each component group includes substantially the same number of second optical components 18ba. When dividing, the components are so divided that a difference between the numbers of any two component groups of second optical components 18ba is up to one. In Fig. 20, the 276 second optical components 18ba are divided into twelve component groups, each including seventeen second optical components 18ba, and four component groups, each including eighteen second optical components 18ba.

Specifically, in sixteen component groups B1 to B16 divided with solid lines in Fig. 20, the component groups having seventeen second optical components 18ba are groups B1 to B5, B8, B9, and B12 to B16; and the component groups having second optical components 18ba are groups B6, B7, B10, and B11. When dividing, the components are divided so that each component group has a minimum circumferential length, i.e., the external shape of each component group is not elongated. Specifically, the length difference between the longer side and the shorter side of a rectangle respectively circumscribing each component group is minimized. For example, the ratio of the length of the shorter side to the length of the longer side of a rectangle respectively circumscribing each component group is set to be 1/2 or more.

Then, suppose that the light reflected from the sixteen first optical components 18aa selected in Fig. 19 enters certain second optical components 18ba in each of the component groups B1 to B16 in the second fly's-eye optical system 18b. When Pi represents the number of the second optical components included in the i-th (i=1 to 16) component group of the second fly's-eye optical system 18b, and Ri represents the number of the second optical components included in the i-th (i=1 to n) component group in the sixteen second optical components corresponding to any sixteen of the first optical components, the evaluation value H mentioned above is defined as the following equation (1).

$$H = \sum_{i=1}^{n} (Ri/n/Pi/A) \times \log_2 (n \times Pi \times A/Ri) \qquad (1)$$

*where*

$$A = \sum_{i=1}^{n} Ri/n/Pi$$

In equation (1), the value of the term in which the value of Ri is zero is calculated as zero. Evaluation value H is the so-called "entropy" and is an index of the position dispersibility of the second optical components 18ba, in which light reflected by the selected sixteen of the first optical components 18aa enters. When the evaluation value H, which changes according to the position dispersibility of the second optical components 18ba in which the light reflected from any sixteen of the first optical components 18aa is incident, the profile of the light intensity distribution in the exit pupil of the illumination optical apparatus is evaluated to be substantially rotation symmetrical with respect to an axis or substantially symmetrical and substantially identical in shape with respect to two perpendicular directions.

For example, when the second optical components 18ba (hatched optical components in Fig. 20), in which the light reflected from the sixteen selected first optical components 18aa is incident, as shown in Fig. 20, are distributed so that one is provided for each of the component groups B1 to B16, evaluation value H becomes maximum as expressed by the following equation (1a).

$$H=1/16/17/0.05801\times\log_2(16\times17\times0.05801)\times12+1/16/18/0.05801\times\log_2$$
$$(16\times18\times0.05801)\times4\approx1.790 \quad (1a),$$

where $A=(1/16/17)\times12+(1/16/18)\times4\approx5.801\times10^{-2}=0.05801$

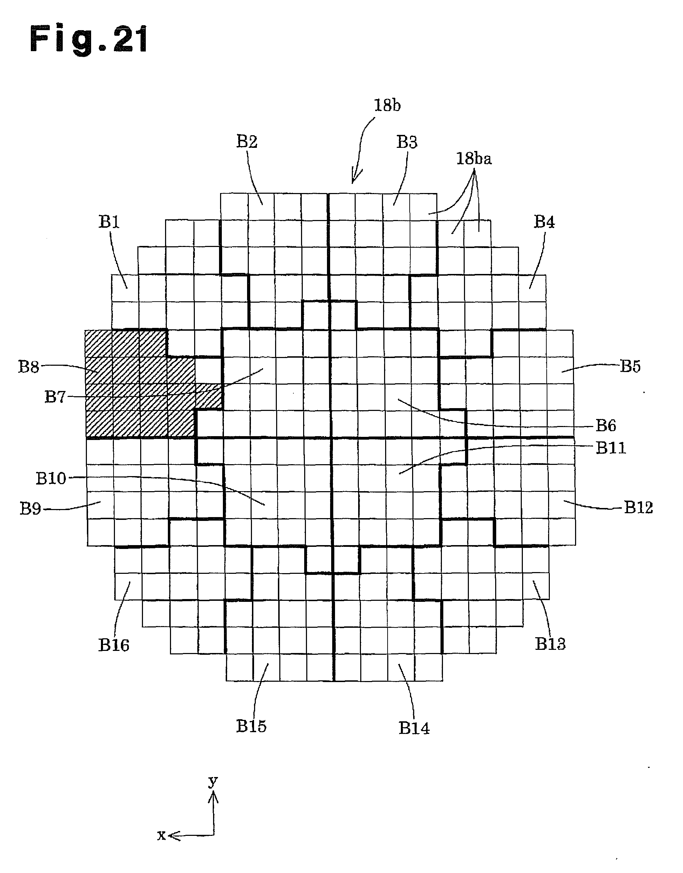

When the second optical components 18ba, in which the light reflected from the sixteen selected first optical components 18aa is incident, as shown by the hatching in Fig. 21, are not well distributed and concentrate in one component group B8, the evaluation value H becomes minimum as expressed by the following equation (1b).

$$H=16/16/17/0.05882\times\log_2(16\times17\times0.05882/16)\approx0 \quad (1b),$$

where $A=(16/16/17)\approx5.882\times10^{-2}=0.05882$.

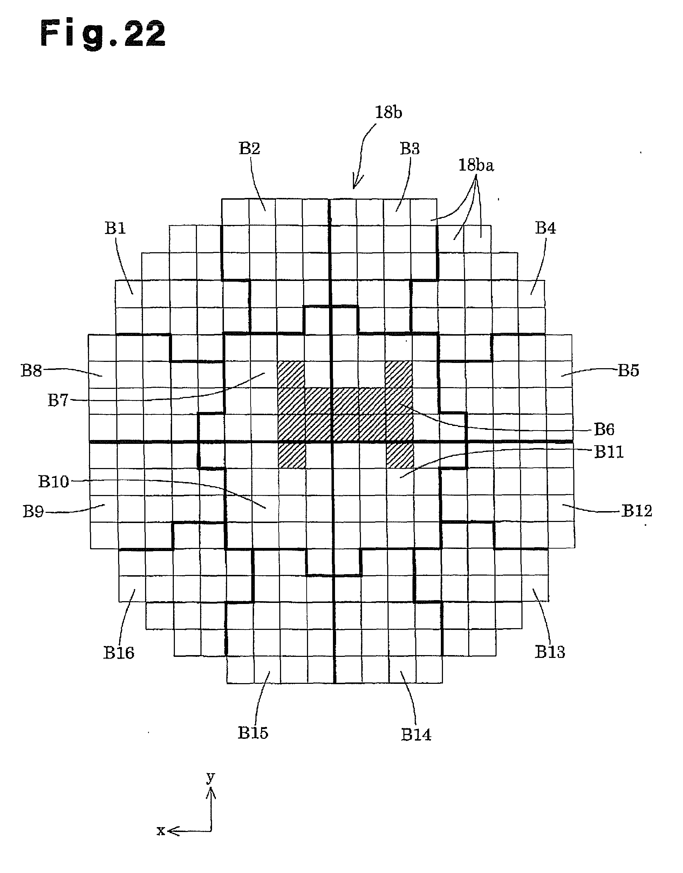

In this example, the second optical components 18ba, in which the light reflected from the sixteen selected first optical components 18aa is incident, as shown by the hatching in Fig. 22, are rather not well distributed to almost concentrated into two component groups B6 and B7. Consequently, the evaluation value H, as expressed in the following equation (1c), is less than the average 0.8948 of the maximum value 1.790 and the minimum value 0.

$$H=7/16/18/0.05556\times\log_2(16\times17\times0.05556/7)\times2+1/16/18/0.05556\times\log$$
$$_2(16\times18\times0.05556)\times2\approx0.4647<0.8948 \quad (1c),$$

where $A=(7/16/18)\times2+(1/16/18)\times2\approx5.556\times10^{-2}=0.05556$

As described above, it is preferable that in each component group of at least one of at least either one of the first fly's-eye optical system 18a and second fly's-eye optical system 18b, a plurality of the concave reflection mirror components (optical components) have different focal distances. In particular, for light beams from a plurality of second concave reflection mirror components 18ba of second fly's-eye optical system 18b, a circular-arc illumination region on the mask M may be illuminated via the condenser optical system 19 in an overlapping manner. The light beams may not be completely superposed thereon and may be slightly displaced from each other due to the aberration of a light guide optical system. In such a case, the displacement of the light beams may be alleviated by making focal distances of a plurality of second concave reflection mirror components 18ba different from each other.

As described above, each of the first concave reflection mirror components has a circular-arc external shape while each of the second concave reflection mirror components has a rectangular external shape. However, the invention is not limited thereto. It should be appreciated that each optical component may have various external shapes, such as a rectangle, a circle, and/or an ellipse. According to one embodiment, the shape of first concave reflection mirror component 18aa of first fly's-eye optical system 18a may be a circular arc identical or not identical to that of the illumination region on the mask face. For example, the external shape of first concave reflection mirror component 18aa may be a rectangle while that of the illumination region on the mask face may be a circular arc. Also, as described above, the present invention is applicable to all the optical components. However, the invention is not limited thereto. It should be appreciated that optical components in only one specific required region may be incorporated in the invention.

As described above, the present invention is applicable to an illumination optical apparatus having a reflection optical integrator. However, the invention is not limited thereto. It should be appreciated that the illumination optical apparatus having a refraction optical integrator may be incorporated in the invention, for example. In this case, the first fly's-eye optical system and the second fly's-eye optical system are configured by arranging optical components such as micro-lens components in parallel.

As described above, the present invention is applicable to the illumination optical apparatus of the EUVL exposure apparatus including the reflection mask M. However, the invention is not limited thereto. It should be appreciated that a general illumination apparatus for illuminating an illumination surface with light from a light source may also be incorporated in the invention.

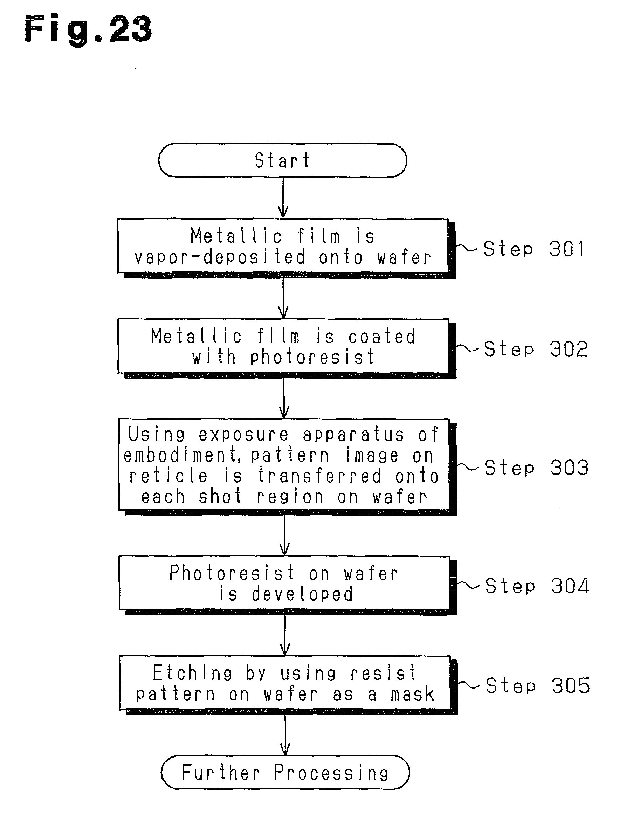

In the exposure apparatus according to one embodiment, micro-devices (semiconductor devices, image-pickup devices, liquid crystal display devices, and thin-film magnetic heads) can be manufactured by illuminating a mask with an illumination system (an illumination process) and by exposing a pattern to be transferred and formed on the mask onto a photosensitive substrate using a projection optical system (an exposure process). A process for obtaining semiconductor devices, such as the micro-devices, by forming a predetermined circuit pattern on a wafer as the photosensitive substrate using the exposure apparatus according to one embodiment will be described below with reference to the flowchart shown in Fig. 23.

First, in step 301 shown in Fig. 23, metallic films are vapor-deposited onto a plurality of wafers in one lot. Next, in step 302, the metallic films on the wafers are coated with a photoresist. Then, in step 303, by using the exposure apparatus described above, a pattern image on a mask (a reticle) is sequentially exposed and transferred onto each shot region of the wafers via a projection optical system.

Thereafter, in step 304, the photoresist on the wafers is developed. Then, in step 305, a circuit pattern corresponding to the pattern on the mask is formed on each shot region on each wafer by etching the resist patterns on the wafers as masks. Then, by forming a circuit pattern on an upper layer, devices such as semiconductor devices are manufactured for further processing. According to the process for manufacturing semiconductor devices, semiconductor devices having an extremely fine circuit pattern can be obtained with a high throughput.

In the EUVL exposure apparatus described above, a laser plasma light source is used for a light source for supplying EUV light. However, the invention is not limited thereto. It should be appreciated that other appropriate light sources for supplying the EUV light, such as a synchrotron radiation (SOR) light source, may also be used.

As described above, each reflection mirror component of the first fly's-eye optical system and the second fly's-eye optical system may have either a concave shape or various other shapes, such as convex, planar, and non-spherical shapes. The shapes of all the reflection mirror components of the first fly's-eye optical system are not necessarily the same. Furthermore, an actuator may be arranged for adjusting the position and the angle of each reflection mirror component. By doing so, the correspondence relationship between reflection mirror components 18aa of first fly's-eye optical system 18a and reflection mirror components 18ba of second fly's-eye optical system 18b may be arbitrarily changed. For example, when the illumination conditions are changed, the illumination intensity distribution can be adjusted.

As described above, on the exit pupil of the illumination optical system, the illumination intensity distribution that is rotation symmetrical with respect to an axis is formed. Furthermore, when it is preferable that the entire intensity distributions be substantially constant in broad perspective, the correspondence relationship between the reflection mirror components 18aa and reflection mirror components 18ba may be established so as to be almost constant from a broad perspective.

**Claims**

1. An illumination optical apparatus for illuminating an illumination surface with light from a light source, the illumination optical apparatus comprising:

   a first fly's-eye optical system having a plurality of first optical components arranged in parallel along an optical path between the light source and the illumination surface; and
   a second fly's-eye optical system having a plurality of second optical components arranged in parallel along an optical path between the first fly's-eye optical system and the illumination surface, the second optical components respectively arranged in correspondence with the first optical components;

   wherein the illumination surface is illuminated with light from each of the second optical components in an overlapping manner; and
   wherein the corresponding relationship of the plurality of first optical components and the plurality of second optical components is established so that an intensity distribution profile of light in an exit pupil of the illumination optical apparatus is substantially rotationally symmetrical with respect to an axis or substantially symmetrical and substantially identical in shape in two perpendicular directions with respect to an axis.

2. The illumination optical apparatus according to claim 1, wherein:

the first fly's-eye optical system includes an N number of component groups, each group including an N number of first optical components;

the second fly's-eye optical system includes an N number of component groups, each group including an N number of second optical components; and

the corresponding relationship of the plurality of first optical components and the plurality of second optical components is established so that light passing through an i-th (i=1 to N) first optical component in each component group of the first fly's-eye optical system enters the second optical components in an i-th (i=1 to N) component group of the second fly's-eye optical system.

3. The illumination optical apparatus according to claim 1, wherein:

the first fly's-eye optical system includes an N number of component groups, each group including an n number of first optical components;

the second fly's-eye optical system includes an N number of component groups, each group including an n number of second optical components;

the corresponding relationship of the plurality of first optical components and the plurality of second optical components is established so that light passing through each first optical component in an i-th (i=1 to N) component group of the first fly's-eye optical system enters the second optical components in an i-th (i=1 to N) component group of the second fly's-eye optical system; and wherein

each component group of the first fly's-eye optical system and each component group of the second fly's-eye optical system is inscribed with a rectangle having a longer side and a shorter side, in which a ratio of the length of the shorter side relative to the length of the longer side is 1/2 or greater.

4. The illumination optical apparatus according to claim 1, wherein:

the first fly's-eye optical system includes an N number of component groups, each group including an n number of first optical components;

the second fly's-eye optical system includes an n number of component groups, each group including an N number of second optical components; and

the corresponding relationship of the plurality of first optical components and the plurality of second optical components is established so that light passing through an i-th (i=1 to n) first optical component in at least one of the component groups of the first fly's-eye optical system enters the second optical components in an i-th (i=1 to n) component group of the second fly's-eye optical system.

5. The illumination optical apparatus according to claim 4, wherein the light passing through the i-th (i=1 to n) first optical component in each one of the component groups of the first fly's-eye optical system enters the second optical components in the i-th (i=1 to n) component group of the second fly's-eye optical system.

6. The illumination optical apparatus according to any one of claims 2 to 5, wherein in each component group of at least one of the first fly's-eye optical system and the second fly's-eye optical system, the plurality of optical components in each component group have different focal distances.

7. The illumination optical apparatus according to any one of claims 1 to 6, wherein the plurality of first optical components and the plurality of second optical components are each formed by a concave reflection mirror.

8. The illumination optical apparatus according to any one of claims 1 to 7, wherein each of the first optical components has a circular-arc external shape, and each of the second optical components has a rectangular external shape.

9. The illumination optical apparatus according to any one of claims 1 to 8, wherein the first optical components included in one of the component groups of the first fly's-eye optical system are arranged adjacent to each other.

10. The illumination optical apparatus according to any one of claims 1 to 9, wherein the second optical components included in one of the component group of the second fly's-eye optical system are arranged adjacent to each other.

11. An illumination optical apparatus for illuminating an illumination surface with light from a light source, the illumination optical apparatus comprising:

a first fly's-eye optical system having an m number of first optical components arranged in parallel along an optical path between the light source and the illumination surface; and
a second fly's-eye optical system having an m number of second optical components arranged in parallel along an optical path between the first fly's-eye optical system and the illumination surface, the m number of second optical components respectively arranged in correspondence with the m number of first optical components;

wherein the illumination surface is illuminated with light from each of the second optical components in an overlapping manner; and
wherein when the m number of second optical components are hypothetically divided into an n number of component groups and an n number of any of the first optical components are arranged adjacent to one another in the first fly's-eye optical system, where n is obtained by rounding off decimal places of a square root of m so that each component group includes substantially the same quantity of the second optical components and each component group is inscribed with a rectangle having a longer side and a short side, in which a ratio of the length of the shorter side relative to the length of the longer side is 1/2 or greater, and when the quantity of the second optical components included in an i-th (i=1 to n) component group of the second fly's-eye optical system is represented by Pi, and the quantity of the second optical components included in an i-th (i=1 to n) component group of an n number of the second optical components corresponding to the n number of any of the first optical components is represented by Ri, a corresponding relationship between the m number of first optical components and the m number of second optical components is established so that an evaluation value H is larger than an average of a maximum value and a minimum value of the evaluation value H, the evaluation value H being defined as:

$$H = \sum_{i=1}^{n} (Ri / n / Pi / A) \times \log_2 (n \times Pi \times A / Ri) \qquad (1)$$

*where*

$$A = \sum_{i=1}^{n} Ri / n / Pi.$$

**12.** The illumination optical apparatus according to claim 11, wherein the m number of first optical components and the m number of second optical components are each formed by a concave reflection mirrors.

**13.** The illumination optical apparatus according to claim 11 or 12, wherein each of the m number of first optical components has a circular-arc external shape, and each of the m number of second optical components has a rectangular external shape.

**14.** The illumination optical apparatus according to any one of claims 11 to 13, wherein the m number of first optical components in the first fly's-eye optical system are arranged adjacent to each other.

**15.** The illumination optical apparatus according to any one of claims 11 to 14, wherein the m number of second optical components in the second fly's-eye optical system are arranged adjacent to each other.

**16.** An illumination optical apparatus for illuminating an illumination surface with light from a light source, the illumination optical apparatus comprising:

a first fly's-eye optical system having a plurality of first optical components arranged along an optical path between the light source and the illumination surface; and
a second fly's-eye optical system having a plurality of second optical components arranged along an optical path between the first fly's-eye optical system and the illumination surface, the second optical components respectively arranged in correspondence with the first optical components;

wherein the illumination surface is illuminated with light from each of the second optical components in an overlapping manner;
wherein the first fly's-eye optical system includes an N number of component groups, each group including an N number of first optical components;

wherein the second fly's-eye optical system includes an N number of component groups, each group including an N number of second optical components; and

wherein the corresponding relationship of the plurality of first optical components and the second optical components is established so that light passing through an i-th (i=1 to N) first optical component in each component group of the first fly's-eye optical system enters the second optical components in an i-th (i=1 to N) component group of the second fly's-eye optical system.

17. An illumination optical apparatus for illuminating an illumination surface with light from a light source, the illumination optical apparatus comprising:

a first fly's-eye optical system having a plurality of first optical components arranged along an optical path between the light source and the illumination surface; and
a second fly's-eye optical system having a plurality of second optical components arranged along an optical path between the first fly's-eye optical system and the illumination surface, the second optical components respectively arranged in correspondence with the first optical components;

wherein the illumination surface is illuminated with light from each of the second optical components in an overlapping manner;
wherein the first fly's-eye optical system includes an N number of component groups, each group including an n number of first optical components;
wherein the second fly's-eye optical system includes an N number of component groups, each group including an n number of second optical components;
wherein the corresponding relationship of the plurality of first optical components and the plurality of second optical components is established so that light passing through each first optical component in an i-th (i=1 to N) component group of the first fly's-eye optical system enters each second optical component in an i-th (i=1 to N) component group of the second fly's-eye optical system; and
wherein each component group of the first fly's-eye optical system and each component group of the second fly's-eye optical system are inscribed with a rectangle having a longer side and a shorter side, in which a ratio of the length of the shorter side relative to the length of the longer side is 1/2 or greater.

18. An illumination optical apparatus for illuminating an illumination surface with light from a light source, the illumination optical apparatus comprising:

a first fly's-eye optical system having a plurality of first optical components arranged along an optical path between the light source and the illumination surface; and
a second fly's-eye optical system having a plurality of second optical components arranged along an optical path between the first fly's-eye optical system and the illumination surface, the second optical components respectively arranged in correspondence with the first optical components;

wherein the illumination surface is illuminated with light from each of the second optical components in an overlapping manner;
wherein the first fly's-eye optical system includes an N number of component groups, each group including an n number of first optical components;
wherein the second fly's-eye optical system includes n number of component groups, each group including an N number of second optical components; and
wherein a corresponding relationship between the plurality of first optical components and the plurality of second optical components is established so that light passing through an i-th (i=1 to n) first optical component in at least one of the component groups of the first fly's-eye optical system enters the second optical components in an i-th (i=1 to n) component group of the second fly's-eye optical system.

19. The illumination optical apparatus according to claim 18, wherein the light passing through the i-th (i=1 to n) first optical component in each one of the component groups of the first fly's-eye optical system enters the second optical components in the i-th (i=1 to n) component group of the second fly's-eye optical system.

20. The illumination optical apparatus according to any one of claims 16 to 19, wherein in each component group of at least one of the first fly's-eye optical system and the second fly's-eye optical system, the plurality of optical components in each component group have different focal distances.

21. The illumination optical apparatus according to any one of claims 16 to 20, wherein the plurality of first optical components and the plurality of second optical components are each formed by a concave reflection mirrors.

22. The illumination optical apparatus according to any one of claims 16 to 21, wherein each of the first optical components has a circular-arc external shape, and each of the second optical components has a rectangular external shape.

23. The illumination optical apparatus according to any one of claims 16 to 22, wherein the first optical components included in one of the component groups of the first fly's-eye optical system are arranged adjacent to each other.

24. The illumination optical apparatus according to any one of claims 16 to 23, wherein the second optical components included in one of the component groups of the second fly's-eye optical system are arranged adjacent to each other.

25. An exposure apparatus comprising the illumination optical apparatus according to any one of claims 1 to 24 and exposing a mask pattern arranged on the illumination surface onto a photosensitive substrate.

26. A device manufacturing method, comprising:

an exposure step of exposing the mask pattern onto the photosensitive substrate using the exposure apparatus according to claim 25; and
a development step of developing the photosensitive substrate having the mask pattern exposed thereon.

# Fig.1

# Fig.2

EP 2 020 679 A1

# Fig.3

# Fig.4(a)

18a

18aa

y

x

# Fig.4(b)

18b

18ba

y

x

# Fig.5(a)

Light Intensity

x direction

# Fig.5(b)

Light Intensity

y direction

# Fig.6

# Fig.7(a)

—18aa1
—18aa2
—18aa3
—18aa4
—18aa5
—18aa6
—18aa7
—18aa8
—18aa9

y
x

# Fig.7(b)

18ba1  18ba2  18ba3

18ba4

18ba5

18ba6

18ba7  18ba8  18ba9

y
x

# Fig.8(a)

18aa1
18aa2
18aa3

y
→x

# Fig.8(b)

18ba1    18ba2    18ba3

y
x←

# Fig.9

# Fig.10

# Fig.11

# Fig.12

# Fig.13

# Fig.14

# Fig.15

# Fig.16

# Fig.17

# Fig.18

# Fig.19

18aa    18a

y
↑
└─→x

# Fig.20

# Fig.21

# Fig.22

# Fig.23

```
                    ┌─────────────────┐
                    │      Start       │
                    └─────────────────┘
                             │
                             ▼
        ┌──────────────────────────────────┐
        │        Metallic film is           │
        │   vapor-deposited onto wafer      │── Step 301
        └──────────────────────────────────┘
                             │
                             ▼
        ┌──────────────────────────────────┐
        │      Metallic film is coated      │
        │         with photoresist          │── Step 302
        └──────────────────────────────────┘
                             │
                             ▼
        ┌──────────────────────────────────┐
        │   Using exposure apparatus of     │
        │  embodiment, pattern image on     │
        │   reticle is transferred onto     │── Step 303
        │   each shot region on wafer       │
        └──────────────────────────────────┘
                             │
                             ▼
        ┌──────────────────────────────────┐
        │      Photoresist on wafer          │
        │         is developed              │── Step 304
        └──────────────────────────────────┘
                             │
                             ▼
        ┌──────────────────────────────────┐
        │      Etching by using resist      │
        │   pattern on wafer as a mask      │── Step 305
        └──────────────────────────────────┘
                             │
                             ▼
                    ┌─────────────────┐
                    │ Further Processing│
                    └─────────────────┘
```

## INTERNATIONAL SEARCH REPORT

| International application No. |
| --- |
| PCT/JP2007/058693 |

A. CLASSIFICATION OF SUBJECT MATTER
*H01L21/027*(2006.01)i

According to International Patent Classification (IPC) or to both national classification and IPC

B. FIELDS SEARCHED

Minimum documentation searched (classification system followed by classification symbols)
H01L21/027

Documentation searched other than minimum documentation to the extent that such documents are included in the fields searched
Jitsuyo Shinan Koho        1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2002-343695 A  (Nikon Corp.), 29 November, 2002 (29.11.02), Full text; all drawings (Family: none) | 1-26 |
| A | JP 2001-244168 A  (Nikon Corp.), 07 September, 2001 (07.09.01), Full text; all drawings & US 6833904 B1 | 1-26 |
| A | JP 2003-086500 A  (Canon Inc.), 20 March, 2003 (20.03.03), Full text; all drawings & EP 1293834 A2        & US 2003/053217 A1 & JP 2004-289172 A      & JP 3634782 B2 & US 7126757 B2 | 1-26 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 19 June, 2007 (19.06.07) | 03 July, 2007 (03.07.07) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**INTERNATIONAL SEARCH REPORT**

International application No.

PCT/JP2007/058693

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 2005-150174 A (Canon Inc.),<br>09 June, 2005 (09.06.05),<br>Full text; all drawings<br>& US 2005/099814 A1 | 1-26 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6452661 B